(19) **Europäisches Patentamt / European Patent Office / Office européen des brevets**

(11) **EP 3 125 057 B1**

(12) **EUROPEAN PATENT SPECIFICATION**

(45) Date of publication and mention
of the grant of the patent:
**03.07.2019 Bulletin 2019/27**

(51) Int Cl.:
***G05B 23/02*** *(2006.01)*　***G05B 17/02*** *(2006.01)*

(21) Application number: **14887291.4**

(86) International application number:
**PCT/JP2014/005336**

(22) Date of filing: **21.10.2014**

(87) International publication number:
**WO 2015/145500 (01.10.2015 Gazette 2015/39)**

(54) **SYSTEM-ANALYZING DEVICE, ANALYSIS-MODEL GENERATION METHOD, SYSTEM ANALYSIS METHOD, AND SYSTEM-ANALYZING PROGRAM**

SYSTEMANALYSEVORRICHTUNG, ANALYSEMODELLERZEUGUNGSVERFAHREN, SYSTEMANALYSEVERFAHREN UND SYSTEMANALYSEPROGRAMM

DISPOSITIF D'ANALYSE DE SYSTÈME, PROCÉDÉ DE GÉNÉRATION DE MODÈLE D'ANALYSE, PROCÉDÉ D'ANALYSE DE SYSTÈME, ET PROGRAMME D'ANALYSE DE SYSTÈME

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **27.03.2014 JP 2014065120**

(43) Date of publication of application:
**01.02.2017 Bulletin 2017/05**

(73) Proprietor: **NEC Corporation**
**Tokyo 108-8001 (JP)**

(72) Inventor: **NATSUMEDA, Masanao**
**Tokyo 108-8001 (JP)**

(74) Representative: **Betten & Resch**
**Patent- und Rechtsanwälte PartGmbB**
**Maximiliansplatz 14**
**80333 München (DE)**

(56) References cited:
| EP-A1- 2 442 288 | WO-A1-2013/111560 |
| JP-A- 2003 314 933 | JP-A- 2006 350 698 |
| JP-A- 2010 218 187 | JP-B2- 5 108 116 |
| SG-A1- 188 751 | US-A1- 2011 276 828 |

**EP 3 125 057 B1**

## Description

## Technical Field

The present invention relates to a system-analyzing device, a system analysis method, and a system-analyzing program, by which the state of a system is analyzed.

## Background Art

For the purpose of safely and efficiently managing systems, processing for analyzing the states of the systems based on sensor values obtained from components of the systems is carried out.

The systems are unities or mechanisms configured by elements influencing each other, such as, for example, information and communication technology (ICT) systems, chemical plants, power plants, and motor facilities.

The sensor values are various values obtained from the components of the systems. Examples of the sensor values include: measured values such as the opening degrees of valves, liquid level heights, temperatures, flow rates, pressures, currents, and voltages acquired through sensors disposed in the components of the systems; and predicted values calculated using such measured values. In addition, examples of the sensor values include values of control signals sent by information processing units used for changing the systems to desired operation states. In the present invention, hereinafter, various values obtained from components of a system are referred to as merely as sensor values regardless of the kinds of the various values.

Most of system analysis methods determine whether the states of systems are normal or abnormal, using such sensor values. For example, there are widely used methods in which either or both of the upper and lower limits of each of sensor values obtained from components of target systems are set as threshold values, and it is determined whether the states of the systems are normal or abnormal, based on the result of a determination whether or not each sensor value is beyond the threshold values. The system analysis methods may further include a method in which a failed facility is specified when several predetermined sensor values are beyond threshold values. Hereinafter, a method, in which based on such a sensor value itself, it is determined whether the state of a system is normal or abnormal, or a failure part is specified, is referred to as a first method.

The first method has a problem of such false detection that that the change of the state of a system caused by an internal or external factor such as temperature, a load on the system, or a set value is an abnormality in the system. Further, the first method has a problem that when a threshold value is loosely set in order to avoid such false detection, it is impossible to detect an abnormality in a system to be primarily detected, such as a failure of a facility or an operation mistake, and a possibility arises that the system and the peripheral thereof are seriously damaged.

Other examples of system analysis methods include a method in which regression analysis of sensor values obtained from a component in a system is performed, and it is determined whether the state of the system is normal or abnormal, based on differences between resultant predicted values of other sensor values and the actually obtained sensor values. Hereinafter, such a method of determining whether the state of a system is normal or abnormal utilizing regression analysis of sensor values is referred to as a second method.

The second method makes it possible to calculate predicted values according to the manner of the change of the state of a system (how the state changes), and therefore, is more likely to make it possible to enhance the sensitivity of abnormality detection while suppressing false detection than the first method of determining whether the state of a system is normal or abnormal based on a sensor value itself.

However, it is necessary to avoid multicollinearity when regression analysis is used. The multicollinearity is a phenomenon in which an incomputability problem or poor accuracy is caused when explanatory variables contain a plurality of data items linked to each other in regression analysis. In the present invention, "data item" is allowed to correspond to each item of a plurality of kinds of sensor values obtained from a component in a system, and is used as an item that represents the set of sensor values corresponding to an applicable item, or as an item that represents identification information for identifying sensor values corresponding to the applicable item. An element such as an instrument included in a system operates in conjunction with another element in order to achieve an object of the system, such as information processing, production of chemical products, or energy conversion. Thus, it is considered that a sensor value obtained from a component in a system varies in conjunction with another sensor value in a similar manner. The multicollinearity described above is more likely to occur when regression analysis of such sensor values is used.

With regard to a technology in which multicollinearity is avoided in regression analysis, for example, in PTL 1, a method in which a regression equation is formulated while avoiding multicollinearity, in a state in which a plurality of data items linked to each other are contained as explanatory variables for one regression equation, by using a partial least square (PLS) is described as an example of a method of formulating a regression equation for predicting manufacturing quality.

PTL 2 describes a method of determining a parameter for a regression equation for detecting the abnormality of a plant using PLS in a manner similar to that in PTL 1.

In PTL 3, a method in which data items that correlate strongly with each other are excluded from explanatory variables contained in one regression equation, whereby multicollinearity is avoided, and a regression equation is formulated, is described as an example of a method for formulating a regression equation for detecting the abnormality of a heat pump heat exchanger.

PTL 4 describes a method in which data items are classified into three kinds of the following data items: a data item for an objective variable; a data item for an explanatory variable and with independence; and a data item for an explanatory variable and with collinearity, and one regression equation is allowed to contain only one data item classified into a data item for an explanatory variable and with collinearity, whereby multicollinearity is avoided, and a regression equation is formulated.

**Citation List**

**Patent Document**

PTL 1: Japanese Patent Application Laid-Open Publication No. 2010-218187
PTL 2: Japanese Patent Application Laid-Open Publication No. 2006-350698
PTL 3: Japanese Patent Application Laid-Open Publication No. 2003-314933
PTL 4: Japanese Patent Publication No. 5108116

**Summary of Invention**

**Technical Problem**

For avoiding system stops and accidents caused by failures of facilities, operation mistakes, and the like, it is necessary to find abnormalities in the states of systems, as signs of occurrence of such troubles, as soon as possible. However, it is impossible to find an abnormality in the state of a system, as a sign of a trouble, with high accuracy by the first method of determining whether the state of the system is normal or abnormal utilizing a sensor value itself. This is because a sensor value change associated with any abnormality as a sign of a trouble is buried in a sensor value change associated with an ordinarily possible change of the state of a system, such as a change of temperature, a change of a load on a system, or a change of a set value, and it is impossible to extract only the sensor value change associated with the abnormality with high accuracy. A system, of which the state is normal, and in which a sensor value greatly changes, particularly significantly has the problem described above.

The second method of determining whether the state of a system is normal or abnormal utilizing regression analysis is more likely to make it possible to enhance the sensitivity of abnormality detection while suppressing false detection than the first method of determining the state of a system is normal or abnormal based on a sensor value itself.

However, each sensor value obtained from a component in a system often changes in conjunction with another sensor value, and multicollinearity is more likely to occur, as described above. Accordingly, when the second method is used, it is necessary to formulate a regression equation that makes it possible to avoid multicollinearity while using a plurality of data items corresponding to the kinds of sensor values that are highly relevant to each other in such a way that a change of a sensor value associated with an ordinarily possible change of the state of a system, and a change of a sensor value irrelevant to such a change of a sensor value can be well differentiated.

In each method described in PTLs 1 and 2, a plurality of data items are used as explanatory variables, and a regression equation is formulated using latent variables and objective variables obtained by synthesizing the explanatory variables. However, when the plurality of data items are merely used as the explanatory variables, a data item that hardly contributes to a predicted value of an objective variable, calculated by the regression equation, may be contained in the explanatory variables. In such a case, a problem occurs that it is impossible to detect an abnormality influencing a few data items (more specifically, a sensor value change associated with the abnormality) with high sensitivity.

The method described in PTL 3 has a problem that data items correlated strongly with each other are excluded, and therefore, it is impossible to detect an abnormality appearing in the excluded data items.

The method described in PTL 4 has a problem that data items are divided into data items for objective variables and data items for explanatory variables in advance, and therefore, the result of a determination whether the state of a system is normal or abnormal depends on which data item is selected for an objective variable. For example, when no sensor value difference occurs between data items for objective variables and data items for explanatory variables even if an influence caused by an abnormality appears as a sensor value difference between the data items for objective variables or between the data items for explanatory variables, it is impossible to detect an abnormality, and it is determined that the state of a system is normal even if any abnormality occurs in the system.

Furthermore, when collinearity between explanatory variables is caused by a sensor value change associated with an ordinarily possible change of the state of a system, and a sensor value change associated with an abnormality occurs only between explanatory variables having collinearity between the explanatory variables, it may be impossible to detect such a sensor value change as an abnormality. This is because explanatory variables in a regression equation contain only one data item classified into data items for explanatory variables and with collinearity, and therefore, it is impossible to remove a sensor value change associated with an ordinarily possible change of the state of a system from an actual sensor value change to extract a sensor value change irrelevant to a change of the state of the system (sensor value change that can be abnormal). For removing the sensor value change associated with the change of the state of the system from the actual sensor value change to extract the sensor value change irrelevant to the change of the state of the system, it is necessary that the explanatory variables in the regression equation contain at least two data items or more classified into the data items for explanatory variables and with collinearity.

Furthermore, the methods described in PTLs 1 to 4 have had a problem that it is difficult to select appropriate objective and explanatory variables when the scale of a system is large and complex. This is because in the system having a complex structure, it is difficult to know a range in which a change of an individual internal or external factor, such as a change of temperature, a change of a load on the system, or a change of a set value, influences a change of each sensor value representing the state of the system, and it is difficult to narrow data items to be set as objective and explanatory variables.

EP 2 442 288 A and US 2011/0276828 A represent related art.

Thus, an object of the present invention is to provide a system-analyzing device, an analysis-model generation method, a system analysis method, and a system-analyzing program, by which the state of a target system can be analyzed with high accuracy even if the target system is complex, or multicollinearity occurs between data items. Herein, "state of system can be analyzed" refers to at least the possibility of determining whether the state of a system is abnormal or normal.

**Solution to Problem**

A system-analyzing device according to one aspect of the present is defined in claim 1 and includes an analysis-model generation means that generates an analysis model for analyzing a state of a target system using state information which is a set of information on a plurality of kinds of data items for the target system. The analysis model includes at least one many-body correlation model which is a correlation model including at least: a regression equation containing three or more data items; and a permissible range of a prediction error for the regression equation. The analysis-model generation means includes: a data-item classification means that classifies a data item group contained in the state information into one or more groups; a many-body correlation model generation means that chooses at least one representative data item from data items contained in each of the groups classified by the data-item classification means according to the group, formulates a regression equation for all combinations of two optional data items of data items contained in the group in which the chosen representative data item is excluded, the regression equation containing the two data items and the representative data item, calculates a permissible range of a prediction error for the regression equation, and a fineness degree of the regression equation, and generates a many-body correlation model including at least the formulated regression equation and the permissible range of the prediction error for the regression equation; and a model extraction means that extracts a many-body correlation model that satisfies a fine model condition for a many-body correlation model in which a fineness degree of a regression equation is predetermined, as a many-body correlation model intended to be contained in the analysis model, from a many-body correlation model group generated by the many-body correlation model generation means. When in at least one classified group, fineness degrees of regression equations, formulated by use of a first data item which is one data item optionally selected from data items contained in the group and a second data item which is one of data items contained in a group in which the first data item is excluded and which is identical to the group of the first data item, are calculated by the data-item classification means for all combinations of second data items possible for the first data item, the data-item classification means classifying data items in such a way that at least one of the fineness degrees of the regression equation satisfies a predetermined fine model condition.

An analysis-model generation method according to an example which is not part of the present invention includes; when in at least one classified group, fineness degrees of regression equations, formulated by use of a first data item which is one data item optionally selected from data items contained in the group and a second data item which is one of data items contained in a group in which the first data item is excluded and which is identical to the group of the first data item, are calculated for all combinations of second data items possible for the first data item, by a data-item classification means, classifying, into one or more groups from data item groups contained in state information which is a set of information on a plurality of kinds of data items for a target system in such a way that at least one of the fineness degrees of the regression equations satisfies a predetermined fine model condition; by a many-body correlation model generation means, choosing at least one representative data item from data items contained in each of the classified groups using the state information according to the group, formulating a regression equation for all combinations of two optional data items of data items contained in the group in which the chosen representative data item is excluded, the regression equation containing the two data items and the representative data item, calculating a permissible range of a prediction error for the regression equation, and a fineness degree of the regression equation, and generating a many-body correlation model including at least the formulated regression equation and the permissible range of the prediction error for the regression equation; and by a model extraction means, extracting a many-body correlation model that satisfies a fine model condition for a many-body correlation model in which a fineness degree of a regression equation is predetermined, as a many-body correlation model intended to be contained in an analysis model for analyzing a state of the target system, from a group of the generated many-body correlation model.

A system analysis according to one aspect of invention as defined in claim 7 includes: when in at least one classified group, fineness degrees of regression equations, formulated by use of a first data item which is one data item optionally selected from data items contained in the group and a second data item which is one of data items contained in a group in which the first data item is excluded and which is identical to the group of the first data item, are calculated for all combinations of second data items possible for the first data item, by a data-item classification means, classifying, into one or more groups from data item groups contained in state information which is a set of information on a plurality of kinds of data items for a target system in such a way that at least one of the fineness degrees of the regression equations satisfies a predetermined fine model condition; by a many-body correlation model generation means, choosing at least one representative data item from data items contained in each of the classified groups using the state information according to the group, formulating a regression equation for all combinations of two optional data items of data items contained in the group in which the chosen representative data item is excluded, the regression equation containing the two data items and the representative data item, calculating a permissible range of a prediction error for the regression equation, and a fineness degree of the regression equation, and generating a many-body correlation model including at least the formulated regression equation and the permissible range of the prediction error for the regression equation; by a model extraction means, extracting a many-body correlation model that satisfies a fine model condition for a many-body correlation model in which a fineness degree of a regression equation is predetermined, as a many-body correlation model intended to be contained in an analysis model, from a group of the generated many-body correlation model, and storing, in a predetermined storage device, information on the analysis model containing a group of the extracted many-body correlation model; when state information is newly acquired, by a model-breakage detection means, detecting presence or absence of occurrence of a model breakage which is a phenomenon in which a predicted value for an objective variable in a regression equation of each correlation model, contained in the analysis model represented by the information on the analysis model stored in the predetermined storage device, is beyond a permissible range of a prediction error for the regression equation of the correlation model, using the newly collected state information; and by an abnormality determination means, determining whether a state of a system is abnormal or normal, based on a result of detection by the model-breakage detection means.

A system-analyzing program according to one aspect of the present invention is defined in claim 8, the program for allowing a computer to execute: data-item classification processing in which when in at least one classified group, fineness degrees of regression equations formulated using a first data item which is one data item optionally selected from data items contained in the group, and a second data item which is one of data items contained in a group in which the first data item is excluded and which is identical to the group of the first data item are calculated for all combinations of second data items possible for the first data item, a data item group contained in state information which is a set of information on a plurality of kinds of data items for a target system is classified into one or more groups in such a way that at least one of the fineness degrees of the regression equations satisfies a predetermined fine model condition; many-body correlation model generation processing in which at least one representative data item is chosen from data items contained in each of the classified groups using the state information according to the group, a regression equation is formulated for all combinations of two optional data items of data items contained in the group in which the chosen representative data item is excluded, the regression equation containing the two data items and the representative data item, a permissible range of a prediction error for the regression equation, and a fineness degree of the regression equation are calculated, and a many-body correlation model including at least the formulated regression equation and the permissible range of the prediction error for the regression equation is generated; model extraction processing in which a many-body correlation model that satisfies a fine model condition for a many-body correlation model in which a fineness degree of a regression equation is predetermined is extracted as a many-body correlation model intended to be contained in an analysis model, from a group of the generated many-body correlation model; processing in which information on the analysis model containing a group of the extracted many-body correlation model is stored in a predetermined storage device; model-breakage detection processing in which when state information is newly acquired, presence or absence of occurrence of a model breakage which is a phenomenon in which a predicted value for an objective variable in a regression equation of each correlation model contained in the analysis model represented by the information on the analysis model stored in the predetermined storage device is beyond a permissible range of a prediction error for the regression equation of the correlation model is detected using the newly collected state information; and abnormality determination processing in which it is determined whether a state of a system is abnormal or normal, based on a result of detection in the model-breakage detection processing.

**Advantageous Effects of Invention**

According to the present invention, the state of a target system can be analyzed with high accuracy even if the target system is complex, or multicollinearity occurs between data items.

**Brief Description of Drawings**

Fig. 1 is a block diagram illustrating a configuration example of a system-analyzing device 100 of a first exemplary embodiment.
Fig. 2 is an explanatory diagram representing an example of a method for extracting a fine cross-correlation model by a data-item classification means 1211.
Fig. 3 is an explanatory diagram representing an example of a method for extracting a fine many-body correlation model by a model extraction means 122.
Fig. 4 is an explanatory diagram representing a formulation example of the graph structure of a fine cross-correlation model group.
Fig. 5 is an explanatory diagram representing an example of a method for choosing a representative data item.
Fig. 6 is an explanatory diagram representing an example of the graph structure of a fine cross-correlation model group having two or more clusters.
Fig. 7 is an explanatory diagram representing an example of a method for choosing a representative data item in a case in which the graph structure of a fine cross-correlation model group has two or more clusters.
Fig. 8 is a flowchart representing an example of the operations of the system-analyzing device 100 of the first exemplary embodiment.
Fig. 9 is a flowchart representing an example of the processing flow of processing of generating an analysis model by an analysis-model generation means 12.
Fig. 10 is an explanatory diagram representing an example of a method for choosing a representative data item of a second exemplary embodiment.
Fig. 11 is a block diagram illustrating a configuration example of a system-analyzing device 300 of a third exemplary embodiment.
Fig. 12 is a flowchart representing an example of the operations of an analysis-model generation means 32 of the third exemplary embodiment.
Fig. 13 is a block diagram illustrating a configuration example of a system-analyzing device 400 of a fourth exemplary embodiment.
Fig. 14 is a flowchart representing an example of the operations of the system-analyzing device 400 of the fourth exemplary embodiment.
Fig. 15 is an explanatory diagram representing an example of a method for extracting an abnormality factor candidate data item group.
Fig. 16 is a block diagram illustrating the principal unit of a system-analyzing device according to the present invention.
Fig. 17 is a block diagram illustrating another configuration example of the system-analyzing device according to the present invention.

**Description of Embodiments**

Exemplary Embodiment 1

Exemplary embodiments of the present invention will be described below with reference to the drawings. Each exemplary embodiment will be described below by taking, as an example, the case of applying a system-analyzing device of the present invention to detection of an abnormality of a power plant system.

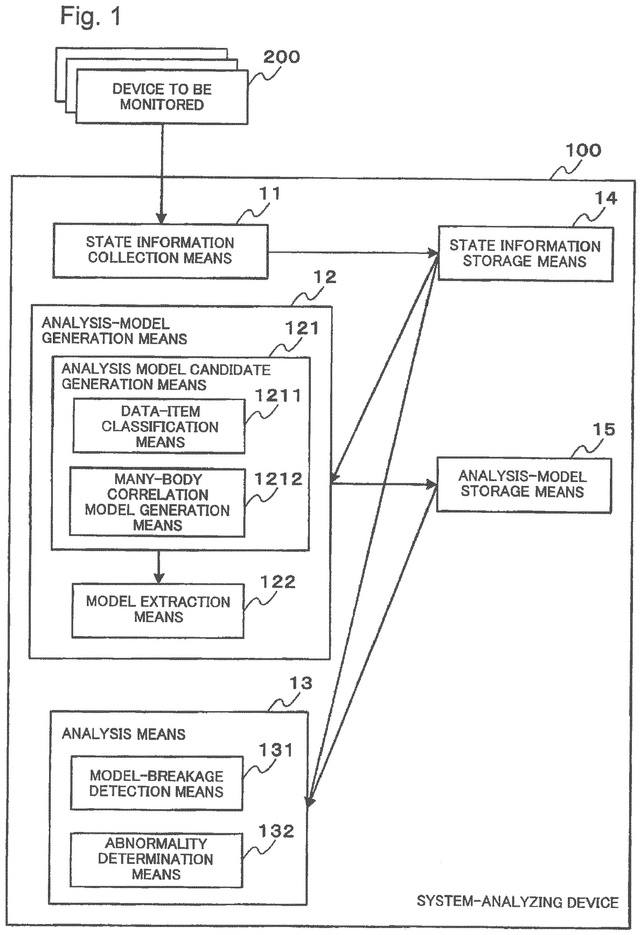

Fig. 1 is a block diagram illustrating a configuration example of a system-analyzing device 100 of a first exemplary embodiment. As illustrated in Fig. 1, the system-analyzing device 100 of this exemplary embodiment is connected to a system to be monitored, including at least one device 200 to be monitored. The device 200 to be monitored is an apparatus or a subsystem as a component included in the power plant system, and is, for example, a turbine, a feed water heater, or a condenser. The device 200 to be monitored also includes an element, such as piping or a signal line, which connects devices. In this exemplary embodiment, it is assumed that the system to be monitored is an overall system such as a power plant system. However, the system to be monitored may be a part of a certain system. In other words, the system to be monitored may be limited to a component, such as a turbine, a feed water heater, or a condenser, for actualizing a function actualized by the certain system.

Each device 200 to be monitored measures, at regular intervals, a sensor value obtained from the device 200 to be monitored, and sends the sensor value to the system-analyzing device 100. In the present description, not only a sensor that is solid hardware such as a usual measurement instrument but also a soft sensor or a control signal is referred to as a sensor. The sensor value is a value obtained from the sensor. Examples of the sensor value include measured values, such as the opening degrees of valves, liquid level heights, temperatures, flow rates, pressures, currents, and voltages, measured by measurement instruments placed in facilities; predicted values calculated from the measured values; and values of control signals. In this exemplary embodiment, each sensor value is expressed in a numerical value such as an integer or a decimal fraction.

In this exemplary embodiment, each sensor corresponding to a sensor value obtained from each device 200 to be monitored is assigned with one data item. A set of sensor values collected at a timing regarded as the same from each device 200 to be monitored is referred to as state information, and a set of data items corresponding to the sensor values contained in the state information is referred to as a data item group. Examples of sensor values collected at a timing regarded as the same include not only sensor values measured at the same time by each device 200 to be monitored and sent to the system-analyzing device 100, but also sensor values measured at times having a time difference within a predetermined range and sent to the system-analyzing device 100, and sensor values collected from each device 200 to be monitored in a series of collection processing by the system-analyzing device 100. A device storing a sensor value acquired by the device 200 to be monitored, such as for example, a data server or a distributed control system (DCS), or a process computer, of which an illustration is omitted, may be included between the device 200 to be monitored and the system-analyzing device 100. In such a case, the device 200 to be monitored may acquire a sensor value at an optional timing and store the sensor value in a storage device, and the system-analyzing device 100 may read, at regular intervals, the sensor value stored in the storage device.

The system-analyzing device 100 is a device that formulates an analysis model for analyzing the state of the system to be monitored while acquiring the state information of the system to be monitored at regular intervals, and analyzes the state of the system to be monitored by using the formulated analysis model. The system-analyzing device 100 includes a state information collection means 11, an analysis-model generation means 12, an analysis means 13, a state information storage means 14, and an analysis-model storage means 15.

The state information collection means 11 collects the state information of the system to be monitored at regular intervals. Hereinafter, the time series data of the state information may be referred to as state series information.

The state information storage means 14 stores the state information, collected by the state information collection means 11, on a time-series basis. In other words, the state information storage means 14 stores, as state series information, the state information collected by the state information collection means 11. The state information storage means 14 may stores, for example, information representing an acquisition time, and the state information (more specifically, a set of collected sensor values), associated with each other. The state information may be, for example, information in which sensor values to be collected are arranged in a predetermined order. The state information storage means 14 of this exemplary embodiment includes at least a storage area for storing state series information corresponding to a predetermined period.

The analysis-model generation means 12 generates an analysis model for analyzing the state of the system to be monitored based on state series information corresponding to a predetermined period, stored in the state information storage means 14.

The analysis model of this exemplary embodiment includes at least one many-body correlation model which is a correlation model including a regression equation containing three or more data items, and the permissible range of a prediction error for the regression equation. More specifically, the analysis model of this exemplary embodiment is a set of correlation models including one or more many-body correlation models.

In the present invention, a model including at least a regression equation that defines a relationship between data items, and the permissible range of a prediction error for the regression equation is referred to as a correlation model, a correlation model including a regression equation containing two data items in the model is referred to as "cross-correlation model", and a correlation model including a regression equation containing three or more data items is referred to as "many-body correlation model". Hereinafter, the cross-correlation model or the many-body correlation model may be referred to simply as a correlation model when it is not necessary to distinguish the cross-correlation model and the many-body correlation model from each other.

By a manager, an optional period including no trouble is set as the predetermined period for the state series information used for generating the analysis model. From the viewpoint of enhancing the sensitivity of abnormality detection, it is preferable that the predetermined period is a period that is as short as possible, to prevent an influence due to the change of the system to be monitored over time. For example, when the cycle of maintenance of the system to be monitored is one year, the predetermined period may be a period that is sufficiently shorter than the cycle, such as one month, one week, or one day. In such a case, it is preferable that the period includes an influence on sensor values due to a factor resulting in great changes in the most sensor values, of the factors of ordinarily possible changes of the state of the system. From the viewpoint of reducing false detection caused by a change of the state of the system to be monitored, it is preferable to use a period that is as long as possible, to comprehensively include changes in sensor values caused by a major internal or external factor. For example, when the system to be monitored is greatly seasonally influenced, the predetermined period may be a period such as nine months or one year.

The analysis-model storage means 15 stores analysis model information which is the information of the analysis model generated by the analysis-model generation means 12. The analysis model information may be, for example, a set of the model information of each of correlation models (one or more many-body correlation models in this exemplary embodiment) included in the analysis model. The model information is, for example, information including an identifier in the correlation model, the information of the regression equation of the correlation model (such as the information of a data item used for an objective variable, the information of a data item used for an explanatory variable, or the information of a relational expression between data items), and information representing the permissible range of a prediction error for the regression equation. The model information may also further include a fineness degree which is an index representing the fineness of the regression equation.

The analysis means 13 analyzes the state of the system to be monitored using the analysis model generated by the analysis-model generation means 12 when state information is newly acquired. As illustrated in Fig. 1, the analysis means 13 includes a model-breakage detection means 131 and an abnormality determination means 132.

When new state information is collected, the model-breakage detection means 131 detects whether a model breakage occurs in each correlation model included in the analysis model shown by the analysis model information stored in the analysis-model storage means 15. The model breakage is a phenomenon in which a prediction error for the regression equation of the correlation model is beyond a permissible range.

In the present invention, occurrence of such a model breakage is used as an index showing that a change of a sensor value corresponding to a data item that is regarded as the objective variable of a regression equation includes a sensor value change irrelevant to a sensor value change associated with an ordinarily possible change of the state of a system (hereinafter referred to simply as "ordinary change").

The model-breakage detection means 131 calculates at least a predicted value at the latest time, for an objective variable in the regression equation of each correlation model included in the analysis model, using, for example, state series information including the newest state information stored in the state information storage means 14, and the analysis model, further calculates a prediction error which is a difference between the calculated predicted value for the objective variable and an actual sensor value, and determines whether the calculated prediction error falls within a permissible range, whereby the presence or absence of occurrence of a model breakage is detected. Further, the model-breakage detection means 131 outputs the result of the detection of the model breakage as model-breakage information.

The model-breakage information may be, for example, information representing the status of the model breakage of each correlation model included in the analysis model. Specifically, the model-breakage information may be information capable of specifying a correlation model in which a model breakage occurs, or may be information capable of specifying a correlation model in which no model breakage occurs. The model-breakage information may contain, in addition to or instead of information capable of specifying a correlation model, information obtained from the correlation model (for example, the information of a data item included in the regression equation of the model, and a calculated prediction error).

Information necessary for model-breakage information depends on an alarm condition regarded as a condition for raising an alarm. For example, when the alarm condition relates to the number of correlation models in which model breakages occur, the model-breakage information may contain information capable of specifying the number of correlation models in which model breakages occur (for example, the presence or absence of a model breakage in each correlation model included in an analysis model, a set of identifiers in a correlation model in which a model breakage occurs, or the like). For example, when the alarm condition relates to the fineness degree of the regression equation of a correlation model in which a model breakage occurs, the model-breakage information may contain information representing the fineness degree of the regression equation of a correlation model in which a model breakage occurs, or information capable of specifying the fineness degree of the regression equation of a correlation model in which a model breakage occurs (such as a set of identifiers in a correlation model in which a model breakage occurs).

The abnormality determination means 132 determines whether or not the status of the model breakage of the analysis model satisfies the alarm condition based on the model-breakage information obtained from the model-breakage detection means 131. If the alarm condition is satisfied as a result of the determination, the abnormality determination means 132 determines that the state of the system to be monitored is abnormal, and notifies a manager and the system to be monitored of the determination result.

For example, the following Expression (1) can be used as the alarm condition.

$$Na > T_a \qquad (1)$$

In the expression, Na is the number of correlation models in which model breakages occur, in correlation models included in the analysis model. $T_a$ is the permitted number of model breakages. For example, in the case of $T_a = 3$, if the number of correlation models in which model breakages occur is 4 or more as a result of calculating a prediction error for the regression equation of each correlation model included in the analysis model, the alarm condition is satisfied, and therefore, the abnormality determination means 132 determines that the state of the system to be monitored is abnormal, and notifies a manager and the system to be monitored of the occurrence of the abnormality, and the like.

Next, a method for generating the analysis model of this exemplary embodiment will be described. The analysis-model generation means 12 of this exemplary embodiment includes an analysis model candidate generation means 121 and a model extraction means 122, as illustrated in Fig. 1. The analysis model candidate generation means 121 includes a data-item classification means 1211 and a many-body correlation model generation means 1212.

The analysis model candidate generation means 121 generates a candidate for a correlation model used (included) in the analysis model. In this example, the data-item classification means 1211 classifies a data item group into one or more groups, and the many-body correlation model generation means 1212 generates one or more many-body correlation models based on the classified groups.

The data-item classification means 1211 classifies a data item group included in state information into one or more groups. More specifically, when in at least one classified group, the fineness degrees of regression equations containing a first data item which is one data item optionally selected from data items contained in the group, and a second data item which is one of data items in which the first data item is excluded, in data items contained in a group which is identical to the group of the first data item, are calculated for all combinations of second data items for the optionally selected first data item, the data-item classification means 1211 classifies data items in such a way that at least one of the fineness degrees of the regression equations satisfies a predetermined fine model condition.

For example, first, the data-item classification means 1211 uses state series information corresponding to a predetermined period to generate a first temporary cross-correlation model and a second temporary cross-correlation model for all combinations of two optional data items in the data item group, respectively. Each of the first temporary cross-correlation model and the second temporary cross-correlation model is a model including at least a regression equation containing the two selected data items, and the fineness degree of the regression equation. However, an objective variable data item (described later) and an explanatory variable data item (described later) in the regression equation are replaced in the second temporary cross-correlation model with respect to the first temporary cross-correlation model.

For example, an auto-regressive with exogenous (ARX) model, as shown by the following Expression (2), can be used for the regression equations of the temporary cross-correlation models.

[Math. 1]

$$\hat{y}(t) = f(u, y) = a_1 y(t-1) + \cdots + a_L y(t-N)$$
$$+ b_0 u(t-K) + \cdots + b_M u(t-K-M) + c \quad \cdots \quad (2)$$

In the expression, t represents an index of state information. The index t of the state information is given consecutive integers of which values increase from old to new occurrences of the state information in the case of arranging the state information in the order of occurrence of the state information. Further, N, K, and M are optional integers. Further, $y(t)$ represents a value of a data item y in a case in which the index of the state information is t. Accordingly, $y(t - N)$ represents the Nth value prior to $y(t)$ in a case in which N is the number of intervals of collection of a sensor value. Further, "..." in Expression (2) represents an omission of terms obtained by incrementing a value to be subtracted from t by one from the left to the right. As an example, "..." represents an omission of $a_2 y(t - 2)$, $a_3 y(t - 3)$, and $a_4 y(t - 4)$ between $a_1 y(t - 1)$ and $a_5 y(t - 5)$, in the case of N = 5. In Expression (2), $y(t)$ with a hat at the left of the first equal sign corresponds to an objective variable. The objective variable is regarded as a predicted value for the data item y in the case in which the index of the state information is t. Further, $y(t - 1)$ to $y(t - N)$ and $u(t - K)$ to $u(t - K - M)$ at the right of the second equal sign correspond to explanatory variables. In this example, sensor values of the data item y in a case in which the index of the state information is $t - 1$ to $t - N$, and sensor values of a data item u in a case in which the index of the state information is $t - K$ to $t - K - N$ are used as the explanatory variables. From the viewpoint of data items, the data item y used in an objective variable is defined as "objective variable data item", and the data item u used only in an explanatory variable is defined as "explanatory variable data item". Further, $f(u, y)$ between the first equal sign and the second equal sign represents that the regression equation is a function in which the two data items u and y are used.

Further, $a_1$ to $a_N$, $b_0$ to $b_M$, c, K, N, and M which are the parameter of Expression (2) are determined so that the fineness degree F of the regression equation is maximum. For example, the prediction accuracy of a regression equation, as shown by the following Expression (3), can be used as the fineness degree F of the regression equation. In Expression (3), y with a bar represents the average value of objective variables during a predetermined period included in state series information (during a period in which an index of state information is 1 to N1).
[Math. 2]

$$F = \left[ 1 - \sqrt{\frac{\sum_{t=1}^{N1} \{y(t) - \hat{y}(t)\}^2}{\sum_{t=1}^{N1} \{y(t) - \bar{y}\}^2}} \right] \quad \cdots (3)$$

Examples of the fineness of a regression equation include two viewpoints of high prediction accuracy and a low generalization error. The above-described example is an example of a fineness degree determined from the viewpoint of the high prediction accuracy, and a fineness degree can also be determined from the viewpoint of the low generalization error. For example, an information criterion may be used in such a case. The fineness degree of the regression equation may be a combination thereof.

Parameters achieving the maximum fineness degree F are determined by, for example, determining $a_1$ to $a_N$, $b_0$ to $b_M$, and c to achieve maximum fineness degrees F for classes of K, N, and M, and then selecting a class of K, N, and M achieving the maximum fineness degree F. Specifically, the data-item classification means 1211, first, sets each maximum value of K, N, and M, formulates a regression equation for each combination of values of K, N, and M, and determines parameters $a_1$ to $a_N$, $b_0$ to $b_M$, and c for each regression equation by a least square method so that the numerator of the second term of the above-described Expression (3) is minimized. Then, the data-item classification means 1211 calculates the fineness degree F of each regression equation, and selects the parameters $a_1$ to $a_N$, $b_0$ to $b_M$, c, K, N, and M of the regression equation having the maximum fineness degree F. In such a manner, a desired regression equation can be obtained. The maximum values of K, N, and M may be set at optional values by a manager.

The data-item classification means 1211 selects a cross-correlation model having the higher fineness degree F of a regression equation, for each class of data items, from a first temporary cross-correlation model group which is a set of first temporary cross-correlation models generated in such a manner, and a second temporary cross-correlation model group which is a set of second temporary cross-correlation models, thereby generating a cross-correlation model group in which two optional data items are associated with one regression equation. In this case, the data-item classification means 1211 selects a cross-correlation model having the higher fineness degree F of a regression equation, of a first temporary cross-correlation model and a second temporary cross-correlation model, for each class of two data items, whereby a cross-correlation model group is obtained as a set of cross-correlation models of all classes for two optional data items selected in such a manner.

The data-item classification means 1211 extracts, as fine cross-correlation models, cross-correlation models, in which a fineness degree F satisfies a predetermined fine model condition in the regression equation of each cross-correlation model, from the cross-correlation model group obtained in such a manner, thereby obtaining a fine cross-correlation model group which is a set of the extracted fine cross-correlation models.

For example, the following Expression (4) is used as the fine model condition. $F_{th}$ represents the threshold value of the fineness degree F of a regression equation.

$$F > F_{th} \quad (4)$$

The threshold value $F_{th}$ of the fineness degree F of a regression equation can be set at an optional value by a manager. From the viewpoint of widening a range targeted for abnormality detection, it is preferable to set the threshold value $F_{th}$ at a low level. From the viewpoint of reducing false detection caused by, e.g., a change of the state of a system, it is preferable to set the threshold value $F_{th}$ at a high level. For detecting a sign of a trouble buried in a change of the state of a system with high accuracy, it is preferable to choose a representative data item for each pattern of the change of the state of the system. Therefore, it is preferable to set the threshold value $F_{th}$ at a high level. For example, if the fineness degree F is a value of 0 to 1, the threshold value $F_{th}$ is preferably a value of 0.7 to 1, and still more preferably a value of 0.8 to 1, for reducing false detection or detecting a sign of a trouble with high accuracy.

The data-item classification means 1211 formulates the graph structure of the extracted fine cross-correlation model group. The graph structure is represented like a network chart with data items included in the regression equation of a cross-correlation model as nodes, and with the regression equation as a line. Hereinafter, a product obtained by connecting three or more nodes through a line in the graph structure is referred to as a cluster.

The data-item classification means 1211 classifies data items to associate each cluster of the graph structure with a data item group which is a group of one data item based on the graph structure of the fine cross-correlation model group. In such classification, the data items are associated with the nodes of the graph structure, and therefore, data items associated with nodes in each cluster become data items included in each data item group. In this case, data items excluded in such a cluster are not targeted for formulating an analysis model.

In such classification of data items, when the fineness degrees of a regression equation formulated using a first data item which is one data item optionally selected from data items contained in a classified data item group, and a second data item which is one of data items obtained by excluding the first data item from data items contained in a data item group which is identical to the group of the first data item is calculated for all combinations of second data items for one optionally selected first data item, data items are classified in such a way that at least one of the fineness degrees of the regression equation satisfies the fine model condition described above.

For each group of the data items classified by the data-item classification means 1211, the many-body correlation model generation means 1212 chooses at least one representative data item from data items contained in the group, and for all combinations of two optional data items obtained by excluding the representative data item from the data items contained in the group, formulates a regression equation containing the two data items and the representative data item. The many-body correlation model generation means 1212 calculates the permissible range of a prediction error for the formulated regression equation, and the fineness degree of the regression equation, and generates a many-body correlation model including at least the formulated regression equation and the permissible range of the prediction error for the regression equation. The many-body correlation model generation means 1212 may generate a many-body correlation model containing a regression equation, the permissible range of a prediction error for the regression equation, and the fineness degree of the regression equation.

In this case, for each data item group classified by the data-item classification means 1211, the many-body correlation model generation means 1212 chooses a representative data item based on the fineness degrees of regression equations, calculated for all of the regression equations containing a class of two optional data items in the data item group. For example, for each data item group, the many-body correlation model generation means 1212 may calculate statistics according to data items in the data item group from the fineness degrees of regression equations, calculated for all of the regression equations containing a class of two optional data items in the data item group, and may choose a representative data item in the data item group based on the calculated statistics according to the data items. For example, the many-body correlation model generation means 1212 may choose an item having the highest statistic as the representative data item. The number of such representative data items is not limited to one. When choosing a plurality of representative data items, the many-body correlation model generation means 1212 may choose the representative data items in descending order of statistic.

Specifically, the many-body correlation model generation means 1212 may accumulate the fineness degrees of the regression equation of each cross-correlation model contained in the cross-correlation model group generated by the data-item classification means 1211, for each data item, whereby for each data item group, a data item having the highest accumulated value of the fineness degrees of the regression equations of data items belonging to the data item group may be regarded as the representative data item. Because a data item used for an objective variable and a data item used for an explanatory variable are associated with the fineness degree of the regression equation of each cross-correlation model contained in the cross-correlation model group, the many-body correlation model generation means 1212 adds the fineness degree of the regression equation to both of the data items in the case of accumulation. The total value of the fineness degrees of the regression equation is equivalent to the statistic.

For example, a regression equation shown by the following Expression (5) can be used as the regression equation of the many-body correlation model.

[Math. 3]

$$
\begin{aligned}
\hat{y}(t) = f(u, x, w, y) = {} & a_1 y(t-1) + \cdots + a_N y(t-N) \\
& + b_0 u(t-K) + \cdots + b_M u(t-K-M) \\
& + d_0 x(t-L) + \cdots + d_Q x(t-L-Q) \\
& + e_0 w(t-P) + \cdots + e_S w(t-P-S) + c \quad \cdots \quad (5)
\end{aligned}
$$

In the expression, K, N, M, L, P, Q, and S are optional integers. In Expression (5), y(t) with a hat at the left hand of the first equal sign also corresponds to an objective variable. The objective variable is regarded as a predicted value of a data item y in a case in which an index of state information is t. Further, y(t - 1) to y(t - N), u(t - K) to u(t - K - M), x(t - L) to x(t - L - Q), and w(t - P) to w(t - P - S) at the right of the second equal sign correspond to explanatory variables.

In this example, a sensor value of the data item y in a case in which the index of the state information is t - 1 to t - N, a sensor value of a data item u in a case in which the index of the state information is t - K to t - K - N, a sensor value of a data item x in a case in which the index of the state information is t - P to t - P - Q, and a sensor value of a data item w in a case in which the index of the state information is t - R to t - R - S are used as explanatory variables. Like the case of Expression (2), however, the data item y used for the objective variable is defined as "objective variable data item", and the data items u, x, and w used only for the explanatory variables are defined as "explanatory variable data items", from the viewpoint of the data items. In the example described above, the two data items (more specifically, the data item x and the data item w) of the four explanatory variable data item correspond to "representative data items".

When a regression equation is formulated using two optional data items and representative data items, the many-body correlation model generation means 1212 formulates regression equations containing, as an objective variable, each of two data items which are not representative data items, and selects a regression equation of which the fineness degree is maximum in the regression equations, thereby generating a many-body correlation model group in which the two optional data items obtained by excluding the representative data items are associated with one regression equation.

For example, using PLS regression, $a_1$ to $a_N$, $b_0$ to $b_M$, $c$, $d_0$ to $d_Q$, $e_0$ to $e_S$, K, L, N, M, P, Q, and S which are the parameters of Expression (5) are determined so that the fineness degree F of the regression equation is maximum. A value of the prediction accuracy of a regression equation, for example, as shown by the above Expression (3), can be used as the fineness degree F of the regression equation.

The parameters achieving the maximum fineness degree F are determined by, for example, determining $a_1$ to $a_N$, $b_0$ to $b_M$, $c$, $d_0$ to $d_Q$, and $e_0$ to $e_S$ to achieve maximum fineness degrees F are for classes of K, L, N, M, P, Q, and S, and then selecting a class of K, L, N, M, P, Q, and S achieving the maximum fineness degree F. Specifically, for example, the many-body correlation model generation means 1212 sets each maximum value of K, L, N, M, P, Q, and S, formulates a regression equation for each combination of values of K, L, N, M, P, Q, and S, and determines the parameters $a_1$ to $a_N$, $b_0$ to $b_M$, $c$, $d_0$ to $d_Q$, and $e_0$ to es for each regression equation by PLS regression. For example, the number of components in the PLS regression may be the number of components from a decrease in the maximum value of a prediction error for state series information used for generating an analysis model until just before an increase in the maximum value in a case in which the number of the components in the PLS regression is sequentially incremented from 1. Finally, the many-body correlation model generation means 1212 calculates the fineness degree F of each regression equation, and selects the parameters $a_1$ to $a_N$, $b_0$ to $b_M$, $c$, $d_0$ to $d_Q$, $e_0$ to $e_S$, K, L, N, M, P, Q, and S of the regression equation having the maximum fineness degree F. In such a manner, the desired regression equation can be obtained. The maximum values of K, L, N, M, P, Q, and S may be set at optional values by a manager.

The many-body correlation model group obtained in such a manner becomes a candidate for a correlation model used as an analysis model.

For example, a range satisfying both of the following Expression (6) and Expression (7) can be used as the permissible range of a prediction error for the regression equation of a many-body correlation model.

$$r_i \leq T_1 \quad (6)$$

$$r_i \geq T_2 \quad (7)$$

In the expressions, $T_1$ is the upper-limit threshold value of a prediction error. Further, $T_2$ is the lower-limit threshold value of the prediction error. Further, $r_i$ is a prediction error for an objective variable calculated using the regression equation of the many-body correlation model at an i-th time. In this case, i represents an identifier for a time in state series information. More specifically, i is an arrangement number in a case in which pieces of state information are arranged in ascending or descending order from a certain reference time to a corresponding time. For example, an i-th time from the start of monitoring may be represented.

As the permissible range of a prediction error for the regression equation of a many-body correlation model, for example, $T_1$ and $T_2$ shown by the following Expression (8) and Expression (9), as being within a range from a value obtained by multiplying the maximum value of the absolute values of prediction errors calculated over the period of state series information used for formulating the regression equation (hereinafter referred to as "prediction errors during calculation period") by -1 to the maximum value of the absolute values of the prediction errors during the calculation period, can be used.

$$T_1 = \max \{|R_1|, |R_2|, ..., |R_{N1}|\} \quad (8)$$

$$T_2 = -T_1 \qquad (9)$$

In the expressions, max {} is a function for outputting a maximum value from input numerical values. Further, |x| is an operator for extracting the absolute value of x. Further, $R_1$ (i = 1 to N1) represents a prediction error for an objective variable calculated from state series information used for formulating the regression equation of the many-body correlation model at an i-th time. N1 is the number of the prediction errors calculated by the state series information using the regression equation of the many-body correlation model.

In addition, using the average value and standard deviation of the prediction errors $R_1$ to $R_{N1}$ calculated over the period of the state series information used for formulation the regression equation, for example, a value obtained by adding the triple of the standard deviation to the average value of the prediction errors may be regarded as $T_1$, and a value obtained by subtracting the triple of the standard deviation from the average value of the prediction errors may be regarded as $T_2$.

The model extraction means 122 extracts a correlation model used for an analysis model from candidates for a correlation model, generated by the analysis model candidate generation means 121. The model extraction means 122 extracts one or more many-body correlation models from a correlation model group generated by the analysis model candidate generation means 121 (many-body correlation model group generated by the many-body correlation model generation means 1212 in this exemplary embodiment), based on the fineness degree of the regression equation of each correlation model.

For example, the model extraction means 122 may extract many-body correlation models that satisfy a predetermined fine model condition as fine many-body correlation models from the many-body correlation model group generated by the many-body correlation model generation means 1212, and may regard a fine many-body correlation model group which is a set of the extracted fine many-body correlation models as analysis models. Further, the model extraction means 122 stores analysis model information including the model information of each extracted fine many-body correlation model in the analysis-model storage means 15.

For example, the above Expression (4) can be used for the fine model condition used for extracting the fine many-body correlation models. The threshold value $F_{th}$ of the fineness degree F of the regression equation can be set at an optional value by a manager. From the viewpoint of widening a range targeted for abnormality detection, it is preferable to set the threshold value $F_{th}$ at a low level. From the viewpoint of reducing false detection caused by, e.g., a change of the state of a system, it is preferable to set the threshold value $F_{th}$ at a high level. Like the temporary cross-correlation models, for example, from the viewpoint of reducing false detection, the threshold value $F_{th}$ is preferably a value of 0.7 to 1, and still more preferably a value of 0.8 to 1, if the fineness degree F is a value of 0 to 1.

Next, the extraction of the fine cross-correlation models and the fine many-body correlation models in this exemplary embodiment will be explained with reference to a specific example.

In the example described below, in the extraction of the fine cross-correlation models and the fine many-body correlation models, the same index of the fineness degree of a regression equation and the same fine model condition are used regardless of whether a model group targeted for the extraction is a cross-correlation model group or a many-body correlation model group. However, a different index of the fineness degree of a regression equation and a different fine model condition may be used depending on a model group targeted for the extraction. An example thereof is use of prediction accuracy as the fineness degrees F of the regression equations of both the cross-correlation models and the many-body correlation models, in which a fine model condition for the cross-correlation models is set at "F > 0.6", and a fine model condition for the many-body correlation models is set at "F > 0.7".

In the example described below, in the extraction of the fine many-body correlation models, the same index of the fineness degree of a regression equation and the same fine model condition are used regardless of the number of representative data items contained in the many-body correlation model group targeted for the extraction. However, a different index of the fineness degree of a regression equation and a different fine model condition may be used depending on the number of representative data items contained in the many-body correlation model group targeted for the extraction. An example thereof is use of prediction accuracy as the fineness degrees F of the regression equations of the many-body correlation models regardless of the number of representative data items, in which a fine model condition for the many-body correlation models is set at "F > 0.6 $\times$ (the number of representative data items)$^{-1/3}$".

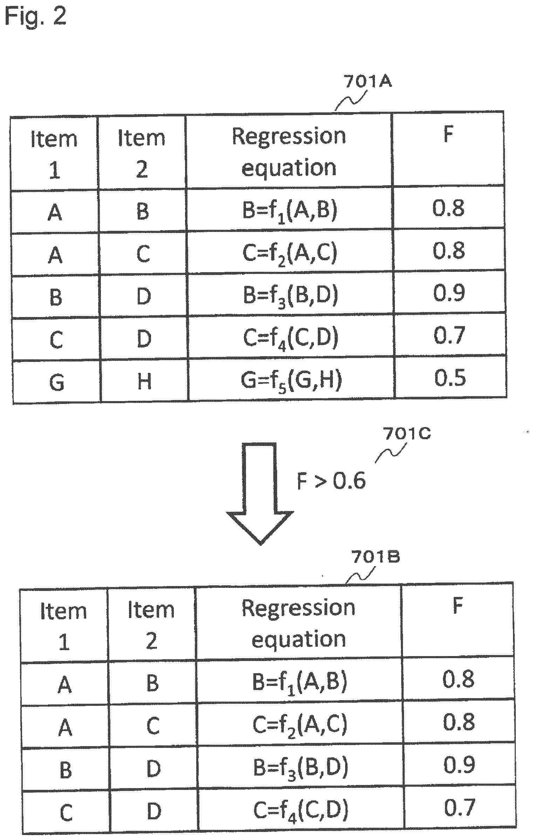

Fig. 2 is an explanatory diagram representing an example of a method for extracting a fine cross-correlation model by the data-item classification means 1211. In Fig. 2, reference sign 701A represents a cross-correlation model group which is a source for extracting a fine cross-correlation model. Reference sign 701B represents an extracted fine cross-correlation model group. Reference sign 701C represents a fine model condition used for extracting the fine cross-correlation models of this example. The columns "Item 1" and "Item 2" in the upper and lower sections of Fig. 2 represent the data items of explanatory variables used in regression equations of the cross-correlation models. Further, the column "Regression equation" represents the regression equations of the cross-correlation models. Further, the column "F" represents the fineness degrees of the regression equations. Each cross-correlation model contained in the cross-correlation model group can also contain the permissible range of a prediction error for a regression equation; however, since the permissible range of a prediction error for a regression equation is not utilized for extracting a fine cross-correlation model, the permissible range is omitted in the drawing. In other explanations, values that are not utilized in the explanations may be omitted below in the drawing.

In this example, the data-item classification means 1211 acquires state series information from the state information storage means 14, and generates the cross-correlation model group 701A. The cross-correlation model group 701A of this example contains five cross-correlation models. The data item group contained in the state series information used for generating the cross-correlation model group 701A of this example includes a data item A, a data item B, a data item C, a data item D, a data item G, and a data item H. The regression equations of the five cross-correlation models included in the cross-correlation model group 701A are $B = f_1(A, B)$, $C = f_2(A, C)$, $B = f_3(B, D)$, $C = f_4(C, D)$, and $G = f_5(G, H)$, respectively. In the expressions, $f_j()$ is a function for calculating the predicted value of an objective variable data item from a data item included inside the parentheses (j is an integer which is an identifier for identifying a regression equation). For a data item included inside the parentheses, not only the value (sensor value) of the data item contained in state series information stored in the state information storage means 14, but also a converted value calculated using the data item, and a past value can be used as the explanatory variables of the function. Further, Fig. 2 shows that the fineness degrees F of the regression equations $B = f_1(A, B)$, $C = f_2(A, C)$, $B = f_3(B, D)$, $C = f_4(C, D)$, and $G = f_5(G, H)$ in each cross-correlation model included in the cross-correlation model group 701A are 0.8, 0.8, 0.9, 0.7, and 0.5, respectively.

The data-item classification means 1211 extracts fine cross-correlation models that satisfy the fine model condition 701C from the cross-correlation model group 701A, to obtain the fine cross-correlation model group 701B. The fine model condition 701C of this example is "fineness degree of regression equation: $F > 0.6$" as shown in Fig. 2. Therefore, the data-item classification means 1211 extracts a cross-correlation model in which the fineness degree F of the regression equation exceeds 0.6, as a fine cross-correlation model, from the five cross-correlation models included in the cross-correlation model group 701A. In this example, four cross-correlation models containing the following four regression equations $B = f_1(A, B)$, $C = f_2(A, C)$, $B = f_3(B, D)$, and $C = f_4(C, D)$, respectively, are extracted into the fine cross-correlation model group 701B.

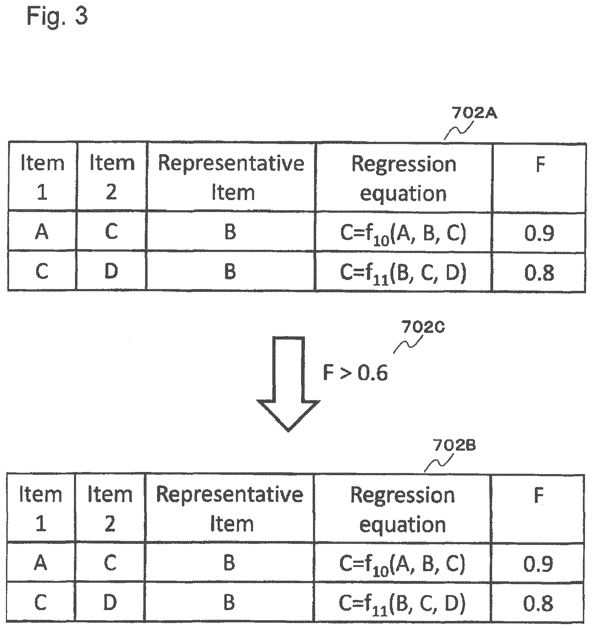

Fig. 3 is an explanatory diagram representing an example of a method for extracting a fine many-body correlation model by the model extraction means 122. In Fig. 3, reference sign 702A represents a many-body correlation model group which is a source for extracting a fine many-body correlation model. Reference sign 702B represents an extracted fine many-body correlation model group. Reference sign 702C represents a fine model condition used for extracting the fine many-body correlation models of this example. The columns "Item 1" and "Item 2" in the upper and lower sections of Fig. 3 represent data items obtained by excluding representative data items from the data items of explanatory variables used in the regression equations of the many-body correlation models. Further, the column "Representative Item" in the table represents the representative data items used in the regression equations of the many-body correlation models.

In this example, the model extraction means 122 acquires the many-body correlation model group 702A from the many-body correlation model generation means 1212. The many-body correlation model group 702A of this example contains two many-body correlation models. The data item group contained in the state series information used for generating the many-body correlation model group 702A of this example includes a data item A, a data item B, a data item C, and a data item D. The regression equations of the two many-body correlation models included in the many-body correlation model group 702A are $C = f_{10}(A, B, C)$ and $C = f_{11}(B, C, D)$, respectively. Further, Fig. 3 shows that the fineness degrees F of the regression equations $C = f_{10}(A, B, C)$ and $C = f_{11}(B, C, D)$ in each many-body correlation model included in the many-body correlation model group 702A are 0.9 and 0.8, respectively.

The model extraction means 122 extracts fine many-body correlation models that satisfy the fine model condition 702C from the many-body correlation model group 702A, to obtain the fine many-body correlation model group 702B. The fine model condition 702C of this example is "fineness degree of regression equation: $F > 0.6$" as shown in Fig. 3. Therefore, the model extraction means 122 extracts a many-body correlation model in which the fineness degree F of the regression equation exceeds 0.6, as a fine many-body correlation model, from the two many-body correlation models included in the many-body correlation model group 702A. In this example, two many-body correlation models containing the following two regression equations $C = f_{10}(A, B, C)$ and $C = f_{11}(B, C, D)$, respectively, are extracted into the fine many-body correlation model group 702B.

Next, the graph structures of the cross-correlation model group and the many-body correlation model group in this exemplary embodiment will be described with reference to a specific example. The example is described below by taking, as an example, a case in which a graph structure is formulated as a directed graph given an arrow from an explanatory variable data item used in the regression equation of a correlation model contained in a target model group to an objective variable data item. However, a graph structure may be formulated as an undirected graph in which a line between nodes is not given an arrow.

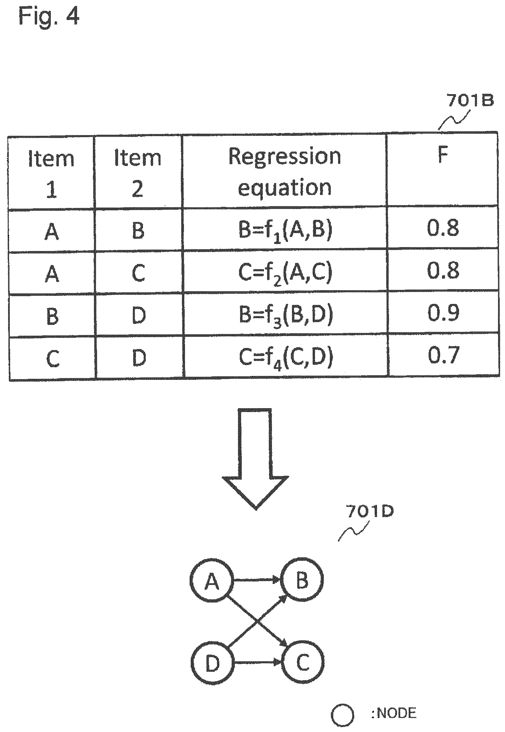

Fig. 4 is an explanatory diagram representing a formulation example of the graph structure of the fine cross-correlation model group 701B represented in Fig. 2. As shown in Fig. 4, first, the data-item classification means 1211 expresses the data items used in the regression equation of each fine cross-correlation model included in the fine cross-correlation model group 701B which is a target model group, as nodes, respectively. Then, the data-item classification means 1211 connects the nodes using a line with an arrow from an explanatory variable data item (data item used only for explanatory variable) to an objective variable data item (data item used for objective variable) for each regression equation to formulate a graph structure 701D. In this example, the data-item classification means 1211 expresses the data item A, the data item B, the data item C, and the data item D as nodes, respectively, and connects the nodes through a line with an arrow from the data item A to the data item B, a line with an arrow from the data item A to the data item C, a line with an arrow from a data item D to a data item B, and a line with an arrow from a data item D to a data item C, respectively, to obtain the graph structure 701D. In Fig. 4, an example in which one cluster remains is shown. However, a plurality of clusters may remain. In this example, all the nodes are effective because an aggregate in which only two nodes are connected through a line does not exist. For example, however, when there is an aggregate in which only two nodes are connected through a line, the aggregate is not recognized as a cluster, and data items corresponding to the nodes included in the aggregate are not targeted for formulating an analysis model.

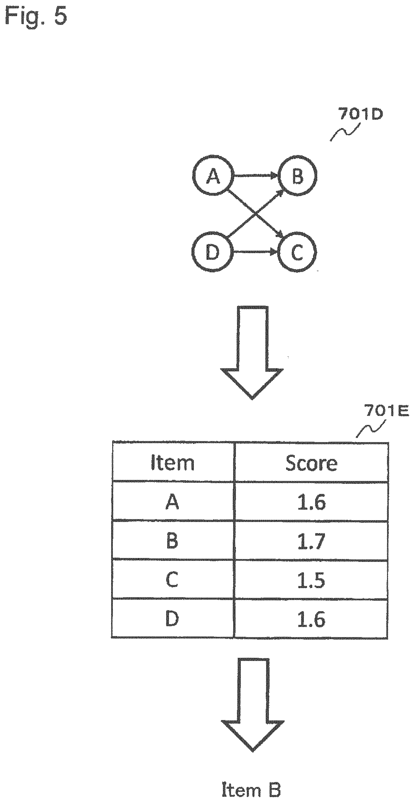

Next, a method for choosing a representative data item in this exemplary embodiment will be described with reference to a specific example. Fig. 5 is an explanatory diagram representing an example of the method for choosing a representative data item. For each cluster, the many-body correlation model generation means 1212 calculates the accumulated value of the fineness degrees F of regression equations for each of data items corresponding to nodes contained in the cluster, for example, based on the graph structure 701D of the fine cross-correlation model group shown in Fig. 4. Specifically, for each cluster contained in the graph structure 701D, the fineness degrees F of regression equations corresponding to an arrow connected to each node are totaled according to each data item corresponding to each of the nodes contained in the cluster, to obtain the accumulated value. The obtained total value is regarded as the score 701E of the data item. In the corresponding data items, a data item having a maximum score 701E is regarded as a representative data item. When there are a plurality of data items having the maximum score 701E, for example, a representative data item may be randomly chosen from the data items. For the score 701E of each data item, in the example shown in Fig. 5, the scores 701E of the data item A, the data item B, the data item C, and the data item D are 1.6, 1.7, 1.5, and 1.6, respectively. Thus, the data item B is selected as the representative data item. In other words, in this example, the data item B is selected as the representative data item of the data item group including the data item A, the data item B, the data item C, and the data item D. This example is an example in a case in which only one cluster is included in the graph structure 701D of the fine many-body correlation model group. However, in a case in which there are a plurality of clusters, a representative data item is chosen for each cluster by a similar method. According to the method of this example, for example, a score can be calculated using prediction accuracy as the fineness degree F of each regression equation as the weight of each regression equation, and therefore, a data item capable of predicting the other data items with the highest accuracy is chosen as the representative data item. From another standpoint, the data item capable of predicting the other data items with the highest accuracy is considered to be able to predict the other data items in the same cluster with the highest accuracy because the data item behaves in an average manner in the data items belonging to the same cluster. Thus, a regression equation capable of separating a sensor value change associated with a change of the state of a system and a sensor value change irrelevant to the change of the state of the system from each other to calculate a predicted value can be formulated by formulating the regression equation using the data item as the representative data item, and therefore, a sign of a trouble buried in the change of the state of the system can be detected.

Next, a method for choosing a representative data item in a case in which the graph structure of a fine cross-correlation model group includes two or more clusters will be described with reference to a specific example.

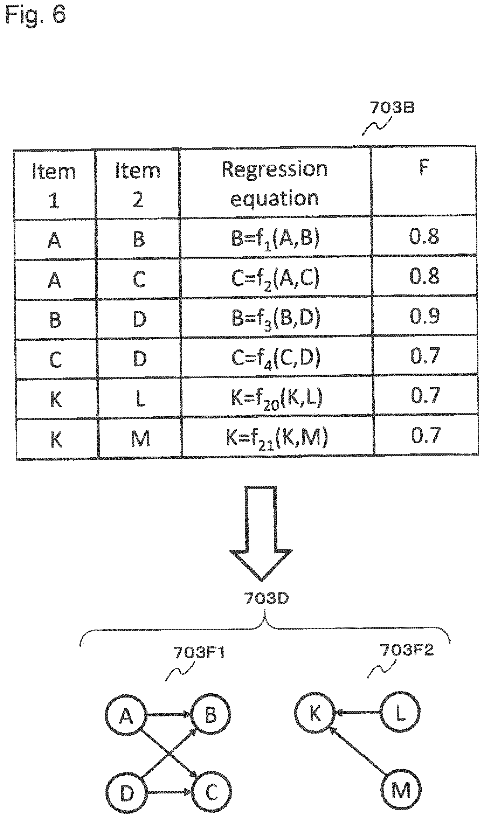

Fig. 6 is an explanatory diagram representing an example of the graph structure of a fine cross-correlation model group having two or more clusters. In Fig. 6, reference sign 703B represents a fine cross-correlation model group targeted for formulating a graph structure. Reference sign 703D represents the graph structure of the fine cross-correlation model group 703B. Each of reference signs 703F1 and 703F2 represents a cluster included in the graph structure 703D. The data-item classification means 1211 expresses data items used in the regression equation of each fine cross-correlation model included in the fine cross-correlation model group 703B as nodes, respectively, and connects the nodes through a line with an arrow from an explanatory variable data item to an objective variable data item for each regression equation to obtain the graph structure 703D. As shown in Fig. 6, the graph structure 703D of this example includes the cluster 703F1 including a data item A, a data item B, a data item C, and a data item D, and the cluster 703F2 including a data item K, a data item L, and a data item M.

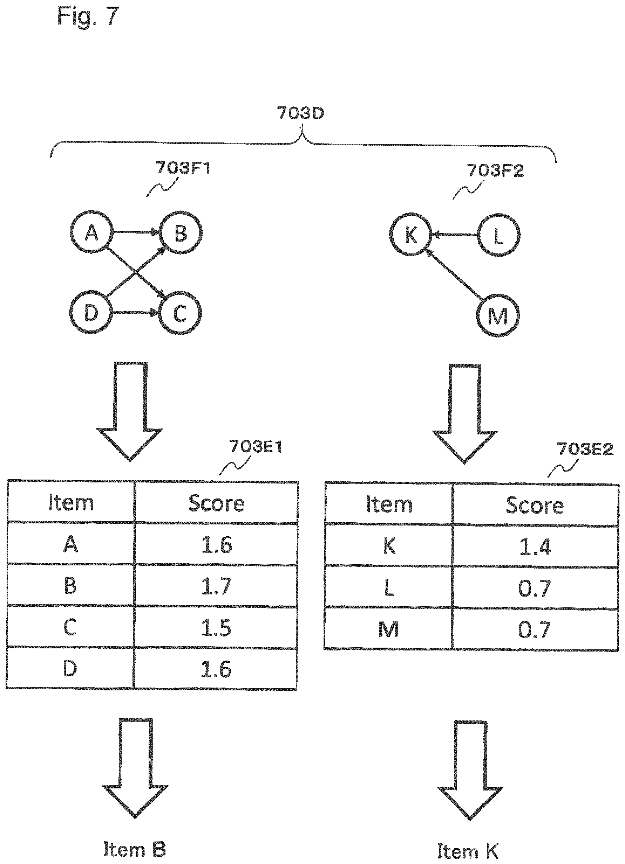

Fig. 7 is an explanatory diagram representing an example of a method for choosing a representative data item in a case in which the graph structure of a fine cross-correlation model group has two or more clusters. For example, for each cluster, the many-body correlation model generation means 1212 calculates the accumulated value of the fineness degrees F of regression equations according to data items included in the cluster based on the graph structure 703D of the fine cross-correlation model group shown in Fig. 7. Specifically, for each cluster included in the graph structure 703D, processing of totaling the fineness degree F of a regression equation corresponding to each of arrows connected to nodes contained in the cluster for data items used in the regression equation is carried out to obtain the total values according to the data items. The obtained accumulated values are regarded as the scores of the data items.

In Fig. 7, the score of each data item included in the cluster 703F1 is shown as 703E1, and the score of each data item included in the cluster 703F2 is shown as 703E2. For each cluster, the many-body correlation model generation means 1212 regards, as a representative data item, a data item having a maximum score in data items included in the cluster. When a plurality of data items having a maximum score are included in one cluster, for example, a representative data item may be randomly selected from the data items. In the example shown in Fig. 7, for the score 703E1 of each data item included in the cluster 703F1, the scores 703E1 of a data item A, a data item B, a data item C and a data item D are 1.6, 1.7, 1.5, and 1.6, respectively. Thus, the data item B is selected as the representative data item of the cluster 703F1. In other words, the data item B is selected as the representative data item of a data item group including the data item A, the data item B, the data item C, and the data item D. For the score 703E2 of each data item included in the cluster 703F2, the scores 703E2 of a data item K, a data item L, and a data item M are 1.4, 0.7, and 0.7, respectively. Thus, the data item K is selected as the representative data item of the cluster 703F2. In other words, the data item K is selected as the representative data item of a data item group including the data item K, the data item L, and the data item M.

The System-analyzing device 100 may be a computer that includes a CPU and a storage medium storing a program, and is operated by the control of the CPU based on the program. In such a case, the state information collection means 11, the analysis-model generation means 12, and the analysis means 13 is actualized by the CPU operated according to the program. The state information storage means 14 and the analysis-model storage means 15 are actualized by the storage medium included in the computer. The state information storage means 14 and the analysis-model storage means 15 may be actualized by corresponding individual storage mediums, or may be actualized by one storage medium.

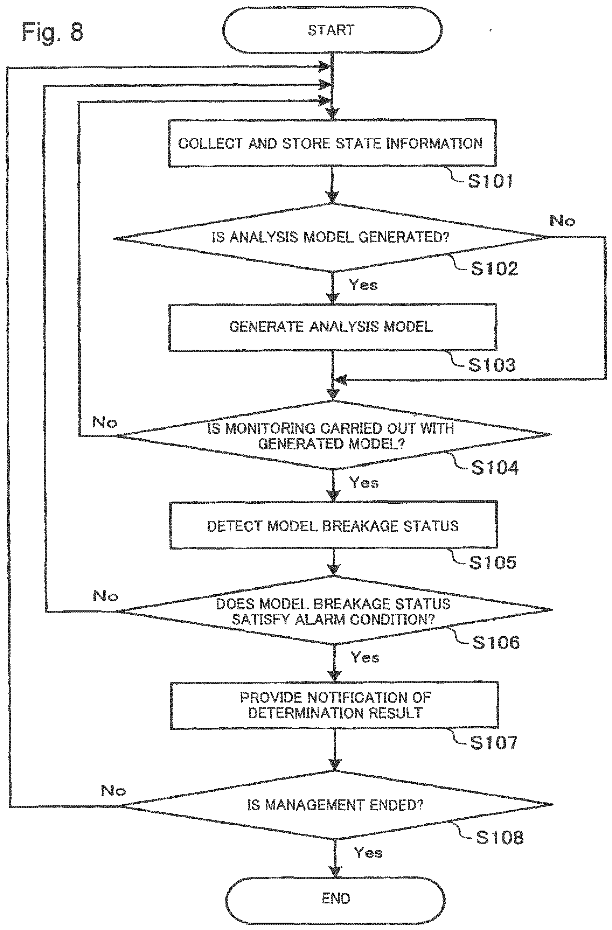

Next, the operations of the system-analyzing device 100 in this exemplary embodiment will be described. Fig. 8 is a flowchart representing an example of the operations of the system-analyzing device 100 of this exemplary embodiment.

In the example shown in Fig. 8, first, the state information collection means 11 of the system-analyzing device 100 collects state information from the device 200 to be monitored, and stores the state information in the state information storage means 14 (step S101). The state information collection means 11 repeats the operation of step S101 until a determination that management is ended (Yes in step S108) is provided. The state information collection means 11 also carries out the operation of collecting state information at regular intervals and storing the state information in the state information storage means 14 while the operations of step S102 to step S107 are carried out.

Then, if current timing is timing for generating an analysis model (Yes in step S102), the analysis-model generation means 12 acquires state series information for a predetermined period used for generating an analysis model from the state information storage means 14, and generates an analysis model using the acquired state series information (step S103). In contrast, if the current timing is not the timing for generating an analysis model (No in step S102), the operation goes to step S104. Whether or not the current timing is the timing for generating an analysis model may be determined, for example, based on whether or not a determination that an analysis model is generated is provided.

In step S104, the analysis means 13 returns to step S101 unless a determination that a target system is monitored using the current analysis model (Yes in step S104) is provided. In contrast, the operation goes to step S105 if the determination that the target system is monitored using the current analysis model (Yes in step S104) is provided.

In step S105, the model-breakage detection means 131 detects the status of a model breakage of the analysis model represented by analysis model information stored in the analysis-model storage means 15 using state information newly collected by the state information collection means 11. More specifically, the model-breakage detection means 131 determines whether or not a model breakage occurs in each many-body correlation model contained in the analysis model, and generates model-breakage information representing the result.

Then, the abnormality determination means 132 determines whether or not the status of the model breakage satisfies an alarm condition based on the model-breakage information provided from the model-breakage detection means 131. If the status of the model breakage satisfies the alarm condition (Yes in step S106), the abnormality determination means 132 notifies a manager or the system to be monitored of the model-breakage information representing the determination result or the status of the model breakage (step S107), and goes to step S108. In contrast, if the status of the model breakage does not satisfy the alarm condition (No in step S106), the abnormality determination means 132 determines detection of no abnormality in the system, does not particularly carry out any processing, and returns to step S101.

The system-analyzing device 100 continues the above-described operations until a determination that management is ended (Yes in step S108) is provided.

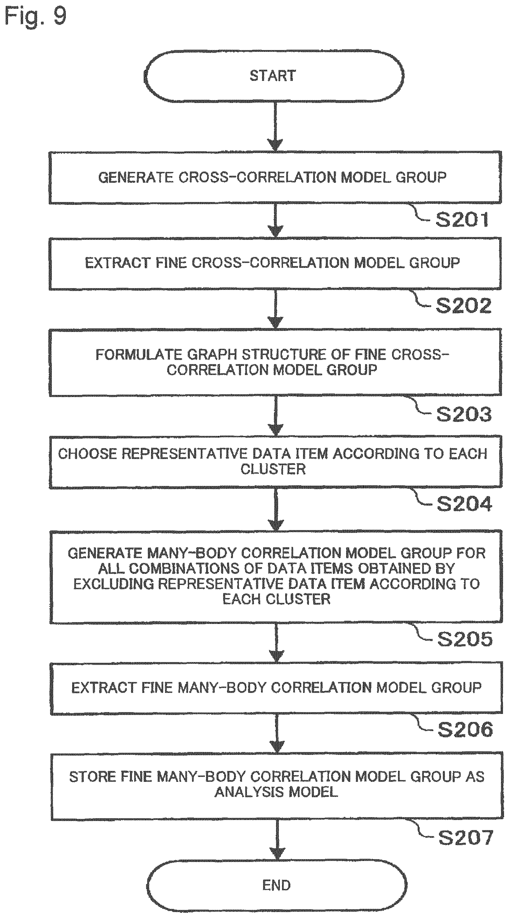

Fig. 9 is a flowchart representing an example of the processing flow of processing of generating an analysis model by the analysis-model generation means 12 (step S103 in Fig. 8). In the example shown in Fig. 9, first, the data-item classification means 1211 acquires state series information corresponding to a predetermined period used for generating an analysis model from the state information storage means 14, and generates a cross-correlation model group for classifying a data item using the acquired state series information (step S201).

Then, the data-item classification means 1211 extracts fine cross-correlation models from the generated cross-correlation model group based on a predetermined fine model condition, to obtain a fine cross-correlation model group (step S202).

Then, the data-item classification means 1211 formulates the graph structure of the obtained fine cross-correlation model group (step S203). In step S203, the data-item classification means 1211 classifies data items based on the formulated graph structure. The data-item classification means 1211 regards each cluster contained in the graph structure as each data item group.

Then, the many-body correlation model generation means 1212 chooses a representative data item according to each data item group classified by the data-item classification means 1211 (step S204).

Then, for each data item group, the many-body correlation model generation means 1212 generates, for all combinations of two optional data items that are obtained by excluding the representative data item and belong to the data item group, many-body correlation models including at least a regression equation using the two data items and the representative data item, and the permissible range of a prediction error for the regression equation, to obtain a many-body correlation model group (step S205).

Then, the model extraction means 122 extracts fine many-body correlation models from the generated many-body correlation model group based on the predetermined fine model condition, to obtain a fine cross-correlation model group (step S206).

Then, the model extraction means 122 stores analysis model information with the obtained fine many-body correlation model group as an analysis model in the analysis-model storage means 15 (step S207).

As described above, according to the system-analyzing device 100 of this exemplary embodiment, an analysis model capable of detecting an abnormality with high sensitivity can be generated even when a target system is complex, or multicollinearity occurs between data items, and therefore, the abnormality of the system can be determined with high accuracy. Examples of the reasons thereof include six features of this exemplary embodiment.

The first feature is one in which the data-item classification means 1211 generates a cross-correlation model group, selects regression equations having high fineness degrees from the regression equations of cross-correlation models contained in the cross-correlation model group, and classifies data items according to each data item contained in the regression equations. As a result, the data items can be classified according to each data item in a case in which an ordinarily possible change of the state of a system, such as a temperature, a load on a system, or a set value, similarly occurs in the value of the data item. This means that data items with similar influences that occur in the values of the data items and are associated with a change of the state of a system (that occur, for example, as the trends of sensor values) can be classified into one group.

Because an index representing the fineness of a regression equation, such as the prediction accuracy of the regression equation using the data items with the similar influences associated with the change of the state of the system, is high, the number of data items that are necessary for obtaining a desired fineness degree and contained in the regression equation can be reduced. Because the number of the data items contained in the regression equation is small, a sign of a trouble influencing a small number of data items can be detected with high sensitivity. Furthermore, because the number of the data items contained in the regression equation is small, the effect of easily specifying a part in which an abnormality occurs can also be obtained in comparison with the case of formulating a regression equation using a large number of data items as explanatory variables. For example, methods described in PTLs 1 and 2 have a problem that specification of a data item influenced by an abnormality is precluded by increasing the number of data items contained as explanatory variables in one regression equation in order to enhance prediction accuracy. According to this exemplary embodiment, even such a problem can be solved.

The second feature is one in which a representative data item is determined for each data item grouped by the above-describe method, and a regression equation including the representative data item and two data items except representative data items is formulated as the regression equation of a correlation model contained in an analysis model. An effect similar to the exclusion of an influence associated with a change of the state of a system from each data item can be obtained by adding a data item for representing the influence associated with the change of the state of the system to the regression equation. Therefore, according to the regression equation formulated by the above-described method, a change of the value of a data item associated with a change of the state of a system can be separated from a change of the value of a data item, unique to the data item, to calculate a predicted value. As described above, a prediction error can be calculated with attention to a change unique to a data item, and therefore, even a change of the value of a data item caused by a sign of such a trouble as to be buried in a change of the value of a data item, associated with a change of the state of a system, only by monitoring a sensor value can be detected with high accuracy.

The third feature is one in which at least a data item having the highest accumulated value of fineness degrees is chosen as a representative data item. A data item having the highest accumulated value of fineness degrees for other data items in a data item group corresponding to a cluster including highly relevant data items is considered to be under the average influence of a change of the state of a system in data items belonging to the data item group. Thus, the representative data item chosen by the above-described method is suitable for a data item for expressing a sensor value change associated with the change of the state of the system, and is more effective at separating a change of the value of a data item, associated with the change of the state of the system, from a change of the value of a data item, unique to the data item.

The fourth feature is one in which a parameter determination method that is not influenced by multicollinearity is used. Therefore, an analysis model can be generated without excluding highly correlated data items. As a result, a problem that it is impossible to find an abnormality between highly correlated data items can be solved. In other words, even such an abnormality as to occur between highly correlated data items can be detected with high accuracy.

The fifth feature is one in which a plurality of regression equations may be formulated for one objective variable in an analysis model. When the plurality of regression equations are formulated for one objective variable, the percentage of the contribution of one regression equation to the result of determination of normality or abnormality for a system decreases, and therefore, a problem that the result of the determination of normality or abnormality for the system may depend on which data item is used for an objective variable can be solved. In other words, the number of regression equations formulated for one objective variable is not limited to one, and therefore, a failure of detection of an abnormality, caused by the limitation of the objective variable, can be prevented.

The sixth feature is one in which selection of a representative data item, an objective variable, and an explanatory variable is not specified in advance, and the representative data item, the objective variable, and the explanatory variable are automatically appropriately determined based on, e.g., the behavior of a sensor value. Thus, a logic relating to the selection of the representative data item, the objective variable, and the explanatory variable is not influenced by system complexity. Therefore, a problem that it is difficult to select appropriate objective and explanatory variables can be solved. In other words, the state of a target system can be analyzed with high accuracy because appropriate objective and explanatory variables can be selected even when the configuration of the target system, and the like are complex.

In addition to the above, the system-analyzing device 100 of this exemplary embodiment has a feature of the high accuracy of narrowing a data item regarded as an abnormality factor. Because representative data items contained in regression equations are common in a data item group which is a set of highly relevant data items, for example, the following determination can be made with attention to a fine many-body correlation model group generated from one data item group in a correlation model contained in an analysis model. For example, when a model breakage occurs in most of the fine many-body correlation model group, it can be determined that a representative data item is more likely to be a data item regarded as an abnormality factor. Conversely, when a model breakage occurs in a minority of the fine many-body correlation model group, it can be determined that the data items obtained by excluding the representative data item are more likely to be data items regarded as abnormality factors.

For the above-described features, it is necessary to choose a representative data item from a data item group grouped according to data items with similar influences on the values of the data items, associated with a change of the state of a system, and in addition, it is preferable that the representative data item is a data item in which the average influence of the change of the state of the system occurs in the group. The system-analyzing device 100 of this exemplary embodiment can choose a representative data item in such a manner. Specifically, it is preferable to choose a data item having the highest accumulated value of fineness degrees (prediction accuracy) in a data item group into which highly relevant strong data item groups are grouped.

In the above explanations, examples in which explanatory variables contain the past values of objective variables (for example, Expression (2) and Expression (5)) are described as examples of the regression equations of correlation models. However, the past values of the objective variables may be excluded from the explanatory variables. In the above examples of the regression equations of the correlation models, the values of data items are used in the objective variables and the explanatory variables. However, numerical values into which the values of the data items are converted may be used. Examples of the numerical values into which the values of the data items are converted include a difference, a power, and the average value of state series information in a predetermined time width.

An example in which each parameter is determined so that the value of prediction accuracy which is a fineness degree is maximum is described as an example of the method for generating the regression equation shown in Expression (2) or Expression (5). However, another fineness degree may be used depending on a purpose. For example, using the inverses of information criteria such as Akaike's information criterion (AIC) and Bayesian information criterion (BIC) as the fineness degrees of regression equations, each parameter may be determined so that the inverses are maximum.

In the above, the method for determining parameters $a_i$ to $a_N$, $b_0$ to $b_M$, and c using a least square method so that the numerator of the second term of Expression (3) is minimized is described as a method for determining the parameters $a_1$ to $a_N$, $b_0$ to $b_M$, and c of a regression equation in a case in which K, N, and M are unchanged. However, the parameters may be determined so that a loss function with a regularization parameter is minimized using the loss function with the regularization parameter used in least absolute shrinkage and selection operator (Lasso), Ridge regression, or the like.

An example in which a representative data item is used for an explanatory variable (for example, Expression (5)) is described as an example of the regression equation of a many-body correlation model. However, the representative data item may be an objective variable. When a plurality of representative data items are used for an objective variable, the synthetic value of the plurality of representative data items may be the objective variable.

In the above, an example in which the number of components in the PLS regression is regarded as the number of components from a decrease in the maximum value of a prediction error for state series information used for formulating a model until just before an increase in the maximum value in a case in which the number of the components in the PLS regression is sequentially incremented from 1 when $a_1$ to $a_N$, $b_0$ to $b_M$, c, $d_0$ to $d_Q$, $e_0$ to $e_s$, K, L, N, M, P, Q, and S which are the parameters of Expression (5) are determined is described. However, the parameters may be determined using Wold's R criterion, Krzanowski's W criterion, Osten's F criterion, or the like.

In the above, an example in which the PLS regression is used is described as an example of a method for determining the parameters $a_1$ to $a_N$, $b_0$ to $b_M$, c, $d_0$ to $d_Q$, and $e_0$ to $e_s$ of a regression equation in a case in which K, L, N, M, P, Q, and S are unchanged. However, the parameters may be determined using another method capable of avoiding an influence caused by multicollinearity between explanatory variables, such as principal component regression (PCR).

In the above, an example in which a representative data item having the highest accumulated value of the fineness degrees of regression equations is chosen is described as an example of a method for choosing a representative data item in a data item group. However, a plurality of data items may be sequentially chosen in descending order of the accumulated value of the fineness degrees of regression equations, as representative data items. When a plurality of representative data items are chosen for one data item group, for example, the number of the representative data items may be increased until satisfying the predetermined number of the representative data items determined in advance by a manager, or the number of the representative data items may be increased until an information criterion exceeds a predetermined threshold value. The number of representative data items for each data item group is desirable to be smaller from the viewpoint of the sensitivity of abnormality detection or the narrowing of abnormality factor data items, and desirable to be larger from the viewpoint of the frequency of a false report.

In the above, an example in which one kind of an index, which is the accumulated value of the fineness degrees of regression equations, is used for choosing the representative data item of a data item group is described. However, plural kinds of indices may be used. Examples of methods for choosing representative data items using the plural kinds of indices include a method in which one data item is selected for each index using an index, which is the accumulated value of the fineness degrees of regression equations, and an index, which is the earliness of the appearance of a change point described later, and such data items are regarded as representative data items.

In the above, an example in which an accumulated value is used as the statistic of the fineness degrees of regression equations in the case of choosing a representative data item in a data item group is described. However, another statistic such as the average value, median, minimum value, or maximum value of the fineness degrees may be used.

In the above, an example in which a statistic is calculated from the fineness degree of a regression equation in the case of choosing a representative data item in a data item group is described. However, a numerical value into which the value of the fineness degree of the regression equation is converted may be used. Examples of the numerical value into which the value of the fineness degree of the regression equation is converted include the square value of the fineness degree of a regression equation, as well as a numerical value obtained by converting the fineness degree of a regression equation that satisfies a fine model condition into 1, and a numerical value obtained by converting the fineness degree of a regression equation that does not satisfy the fine model condition into 0, based on a fine model condition.

In the above, an example in which the system-analyzing device 100 monitors the state of a system to be monitored using one analysis model (analysis model including a many-body correlation model group generated from the same state series information) is described. However, a plurality of analysis models may be created using state series information of which collection periods are different. In such a case, the state of the system to be monitored may be monitored while switching the plurality of analysis models.

In the above, an example in which the system-analyzing device 100 formulates an analysis model only once is described. However, analysis models may be consecutively reformulated.

In the above, an example in which the system-analyzing device 100 monitors the state of a system to be monitored using all regression equations contained in an analysis model for detecting a model breakage is described. However, the state of the system to be monitored (for example, only part of a device 200 to be monitored) may be monitored using only part of the analysis model.

In the above, an example in which a condition that "in a case in which the number of correlation models in which model breakages occur exceeds a predetermined number" is used as an example of an alarm condition. For example, a condition that "in a case in which the accumulated value of the fineness degrees of the regression equations of correlation models in which model breakages occur exceeds a predetermined value" may be used. For example, a predetermined value set in advance is generalized as an alarm threshold value, and a condition that "in the case of exceeding an alarm threshold value for a predetermined period set in advance" can be regarded as an alarm condition. In such a manner, any condition based on model-breakage information can be set as an alarm condition.

In the above, an example in which the system to be monitored is a power plant is described. However, the system to be monitored may be another system as long as one or more many-body correlation models can be generated from information representing the state of the system to be monitored, and the presence or absence of the occurrence of an abnormality can be determined based on the model breakage of the one or more generated many-body correlation models. For example, the system to be monitored may be an IT system, a plant system, a structure, transportation equipment, or the like. In this case, the system-analyzing device 100 generates, for example, an analysis model with the item of data contained in information representing the states of such systems as a data item, and detects a model breakage.

Exemplary Embodiment 2

Next, a second exemplary embodiment of the present invention will be described. This exemplary embodiment is the same as the first exemplary embodiment except a method for choosing a representative data item. Therefore, the same portions as those in the first exemplary embodiment are denoted by the same reference signs, and the descriptions thereof are omitted.

In this exemplary embodiment, a data item of which the value earliest changes on a time-series basis in each data item group, i.e., a data item in which a change point appears earliest is chosen as a representative data item. When a plurality of representative data items are chosen, the representative data items may be chosen in descending order of the earliness of the appearance of the change point of information.

First, a many-body correlation model generation means 1212 of this exemplary embodiment randomly selects one of data items contained in a data item group classified by a data-item classification means 1211. The selected data item is regarded as a reference data item, and a time shift amount between the reference data item and another data item, with the maximum cross-correlation coefficient between the reference data item and the other data item in the data item group, is determined. A data item having the greatest time shift amount toward the past is regarded as the representative data item of the data item group.

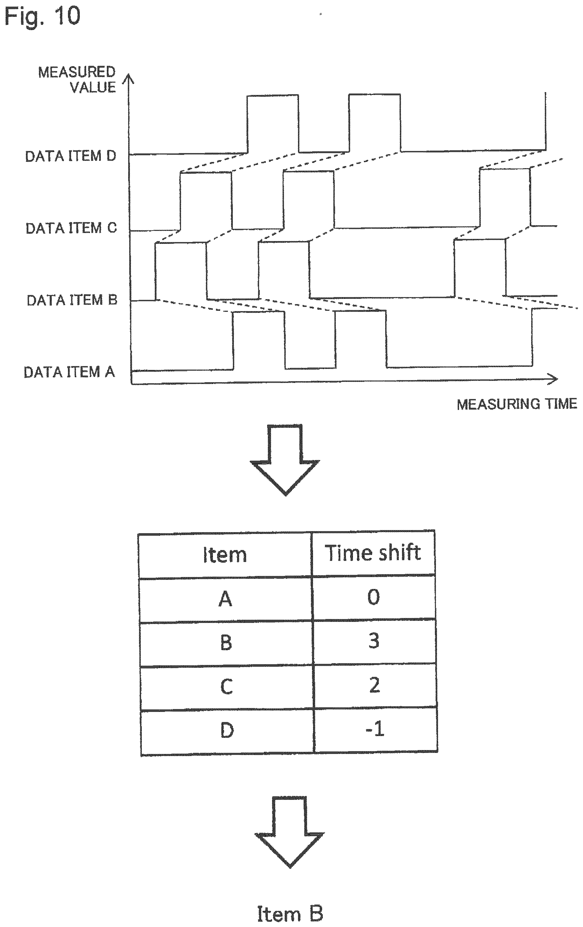

Next, a method for choosing a representative data item in this exemplary embodiment will be described with reference to a specific example. Fig. 10 is an explanatory diagram representing an example of the method for choosing a representative data item in this exemplary embodiment. The example represented in Fig. 10 is an example in which a representative data item is chosen from one data item group generated as a result of being grouped based on the graph structure 701D of the fine cross-correlation model group 701B shown in Fig. 4.

First, the many-body correlation model generation means 1212 randomly selects one data item from data items contained in a data item group corresponding to each cluster of a generated graph structure. The manners of the time series changes of a data item A, a data item B, a data item C, and a data item D (schematic view of time series data) in state series information used for generating an analysis model are shown in the upper section of Fig. 10. In this example, it is assumed that the data item A is chosen as a reference data item. The time shift amounts of the data item A, the data item B, the data item C, and the data item D with respect to the data item A which is a reference data item in this case were 0, 3, 2, and -1, respectively.

In Fig. 10, the amounts of shifting the other data items in a time direction under a condition on which the cross correlation functions of the reference data item A and the other data items have maximum values are shown as time shift amounts. The unit of such a time shift amount is one measurement time interval. A time shift amount that is a positive value shows that the cross correlation function of the data item A which is the reference data item and another data item is a maximum value when the other data item is shifted to the future, i.e., to the right of the paper face. In contrast, a time shift amount that is a negative value shows that the cross correlation function of the data item A which is the reference data item and another data item is a maximum value when the other data item is shifted to the past, i.e., to the left of the paper face. Accordingly, a data item having a time shift amount that has a maximum value is selected as a representative data item in this example. In the example shown in Fig. 10, the data item B is selected as the representative data item.

According to this procedure, a time series relationship is also considered, and therefore, a data item causing a change of the state of a system can be extracted when only data items having similar waveforms are included in one data item group. Because a change of a data item value caused by the change of the state of the system can be separated from a change of a data item value unique to the data item in calculation of a predicted value by formulating a regression equation using the data item causing the change of the state of the system, the change of the value of the data item, caused by such a sign of a trouble as to be buried in the change of the value of the data item associated with the change of the state of the system only by monitoring a sensor value, can be detected. In order to allow only the data items having similar waveforms to be included in the data item group, it is preferable to prevent the past value of an objective variable from being included in the regression equation of a temporary cross-correlation model, and to allow only the data items used in a regression equation of which the fineness degree is high, to be included in the group.

Exemplary Embodiment 3

Next, a third exemplary embodiment of the present invention will be described. This exemplary embodiment is different from each of the exemplary embodiments described above in that not only a many-body correlation model but also a cross-correlation model is used as a correlation model for an analysis model. The following description is presented by taking, as an example, a case in which the function of using the cross-correlation model as the analysis model is added to the configuration of the first exemplary embodiment. However, the function may be added to the second exemplary embodiment. In the following description, the same portions as those in the first exemplary embodiment are denoted by the same reference signs, and the descriptions thereof are omitted.

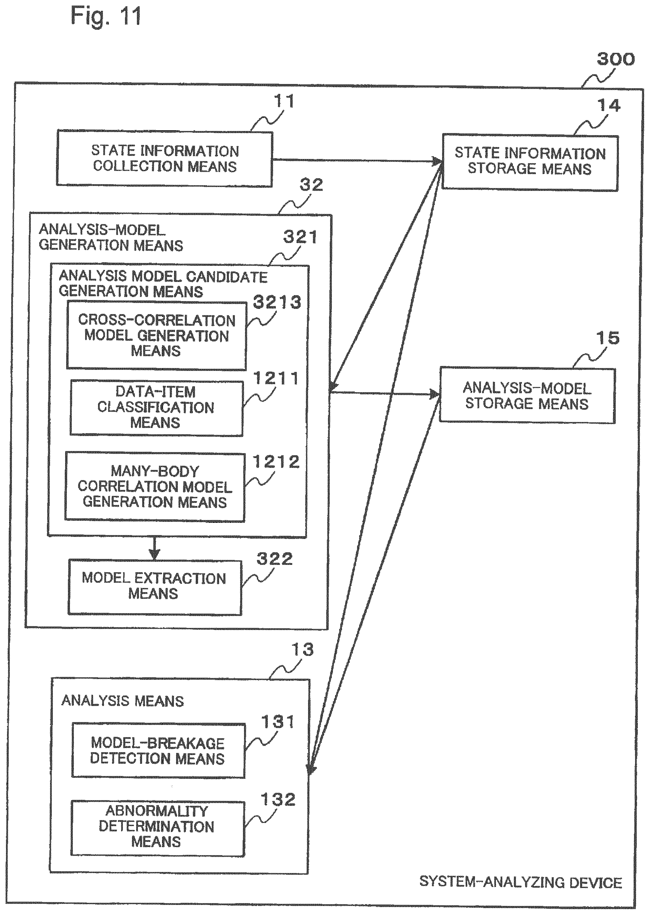

Fig. 11 is a block diagram illustrating a configuration example of a system-analyzing device 300 of this exemplary embodiment. The system-analyzing device 300 illustrated in Fig. 11 is different in comparison with the configuration of the system-analyzing device 100 of the first exemplary embodiment illustrated in Fig. 1, in that the analysis-model generation means 12 is replaced with an analysis-model generation means 32.

The analysis-model generation means 32 includes an analysis model candidate generation means 321 and a model extraction means 322. The analysis model candidate generation means 321 includes a cross-correlation model generation means 3213, a data-item classification means 1211, and a many-body correlation model generation means 1212. In such a manner, this exemplary embodiment is different from the first exemplary embodiment in that the analysis model candidate generation means 321 of the analysis-model generation means 32 further includes the cross-correlation model generation means 3213. The operation of the model extraction means 322 is also different from that of the model extraction means of the first exemplary embodiment.

The cross-correlation model generation means 3213 generates a cross-correlation model which is a candidate for a correlation model contained in an analysis model.

Specifically, the cross-correlation model generation means 3213 formulates a regression equation containing two optional data items for all combinations of the two optional data items, calculates the permissible range of a prediction error for the regression equation and the fineness degree of the regression equation, and generates a cross-correlation model containing at least the formulated regression equation and the permissible range of the prediction error for the regression equation. The cross-correlation model generation means 3213 may generate a cross-correlation model containing the formulated regression equation, the permissible range of the prediction error for the regression equation, and the fineness degree of the regression equation. Hereinafter, a cross-correlation model generated by the cross-correlation model generation means 3213 may be referred to as a cross-correlation model for analysis. A set of cross-correlation models for analysis may be referred to as a cross-correlation model group for analysis. Hereinafter, the cross-correlation model group generated by the data-item classification means 1211 of the first exemplary embodiment may be referred to as a cross-correlation model group for classification in order to distinguish the cross-correlation model group from the cross-correlation model group for analysis.

The data-item classification means 1211 selects a temporary cross-correlation model having the higher fineness degree F of a regression equation, of a first temporary cross-correlation model and a second temporary cross-correlation model obtained by replacing an objective variable data item and an explanatory variable data item with each other in the first temporary cross-correlation model, for two optional data items, thereby generating a cross-correlation model group for classification in which the two optional data items are associated with one regression equation. However, similar selection processing is also carried out in the cross-correlation model generation means 3213. In other words, a cross-correlation model group for analysis, in which two optional data items are associated with one regression equation having a higher fineness degree, of two regression equations in which an objective variable data item and an explanatory variable data item are replaced with each other, is generated.

The model extraction means 322 of this exemplary embodiment has the following function, in addition to the function of the model extraction means 122 of the first exemplary embodiment. In other words, the model extraction means 322 extracts cross-correlation models that satisfy a predetermined fine model condition as fine cross-correlation models for analysis from an analytical cross-correlation model group generated by the cross-correlation model generation means 3213, and regards the group of the extracted fine cross-correlation models for analysis as correlation models to be contained in an analysis model. Accordingly, the analysis model of this exemplary embodiment can contain one or more cross-correlation models, in addition to one or more many-body correlation models.

As a result of extraction, the model extraction means 322 stores, as analysis model information, the information of the many-body correlation and cross-correlation models regarded as the correlation models to be contained in the analysis model, in an analysis-model storage means 15.

The regression equations, indices of the fineness degrees of regression equations, and fine model conditions of the cross-correlation model for analysis and the cross-correlation model for classification may be the same or different.

The methods for calculating the permissible range of a predicted error for a regression equation, indices of the fineness degrees of a regression equation, and fine model conditions of the cross-correlation model for analysis and the many-body correlation model may be the same or different. Any case shown in the first exemplary embodiment can be used.

A method for detecting a model breakage for the cross-correlation model contained in the analysis model is similar to that in the many-body correlation model. Accordingly, a model-breakage detection means 131 in an analysis means 13 may detect the presence or absence of the occurrence of a model breakage for each correlation model contained in the analysis model shown by the analysis model information stored in the analysis-model storage means 15 by a method similar to that of the first exemplary embodiment when new state information is collected.

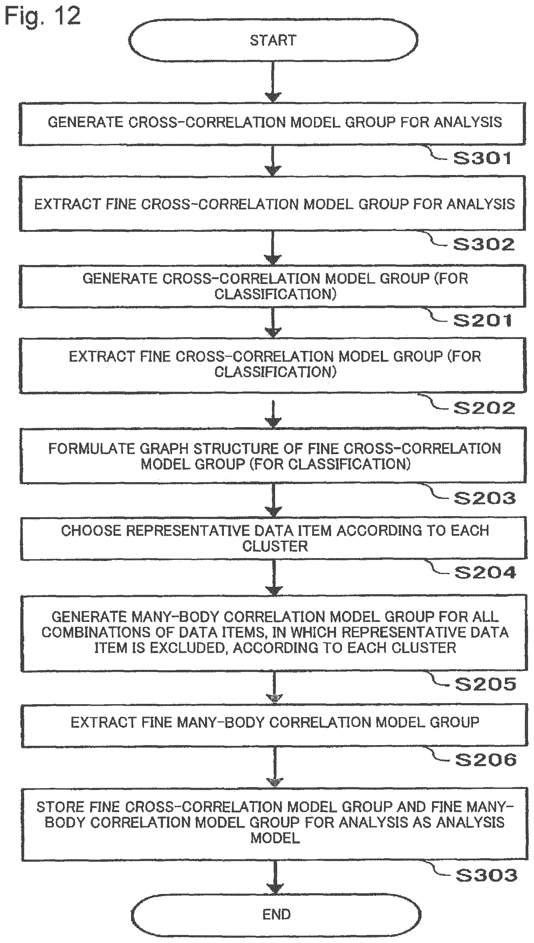

Next, the operations of the system-analyzing device 300 in this exemplary embodiment will be described. Fig. 12 is a flowchart representing an example of the operations of the analysis-model generation means 32 of this exemplary embodiment. In the following description, the same operations as the operations represented in Fig. 9 are denoted by the same reference signs, and the descriptions thereof are omitted.

As represented in Fig. 12, first, in the analysis-model generation means 32 of the system-analyzing device 300 of this exemplary embodiment, the cross-correlation model generation means 3213 acquires state series information corresponding to a predetermined period used for generating an analysis model from a state information storage means 14, and generates a cross-correlation model group for analysis using the state series information (step S301).

Then, the model extraction means 322 extracts fine cross-correlation models for analysis from the generated cross-correlation model group for analysis based on a predetermined fine model condition, to obtain a fine cross-correlation model group for analysis (step S302).

Then, the data-item classification means 1211 and the many-body correlation model generation means 1212 cooperatively generate a many-body correlation model group (steps S201 to S205) by a method similar to that of the first exemplary embodiment, and the model extraction means 322 extracts fine many-body correlation models from the generated many-body correlation model group based on the predetermined fine model condition, to obtain a fine many-body correlation model group (step S206).

Finally, the model extraction means 322 stores analysis model information in the analysis-model storage means 15, with the combination of the fine cross-correlation model group for analysis obtained in step S302 and the fine many-body correlation model group obtained in step S206 as an analysis model (step S303).

As described above, according to this exemplary embodiment, the cross-correlation models are used not only for grouping data items but also as correlation models for an analysis model, and therefore, the range of data items targeted for analysis can be further widened.

When the same regression equation is used in the cross-correlation model for analysis and the cross-correlation model for classification, the data-item classification means 1211 may use the cross-correlation model group for analysis generated by the cross-correlation model generation means 3213 as a cross-correlation model group for classification, on an as-is basis. When the same fine model condition used for extracting the fine cross-correlation model group is used, the fine cross-correlation model group can also be used in common. In other words, the fine cross-correlation model group for analysis may be used as the fine cross-correlation model group for classification, on an as-is basis. In such a case, the processing of steps S201 to S202 in Fig. 12 is omitted.

Exemplary Embodiment 4

Next, a fourth exemplary embodiment of the present invention will be described. This exemplary embodiment is different from each of the exemplary embodiments described above in that the embodiment includes the function of extracting an abnormality factor. The following description is presented by taking, as an example, a case in which the function is added to the configuration of the third exemplary embodiment. However, the function may be added to the first exemplary embodiment or the second exemplary embodiment. In the following description, the same portions as those in the third exemplary embodiment are denoted by the same reference signs, and the descriptions thereof are omitted.

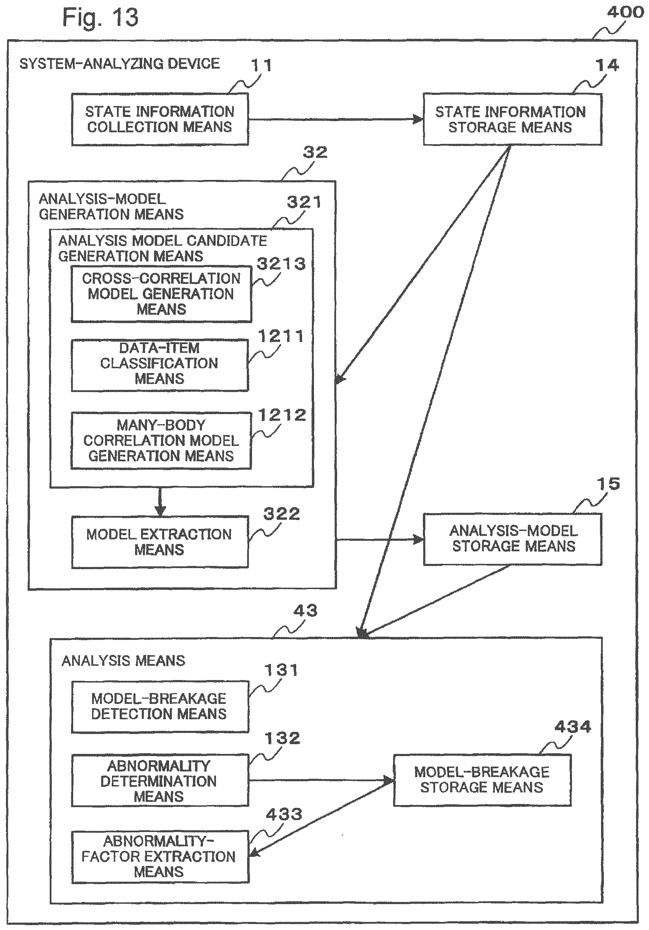

Fig. 13 is a block diagram illustrating a configuration example of a system-analyzing device 400 of this exemplary embodiment. The system-analyzing device 400 illustrated in Fig. 13 is different in comparison with the configuration of the system-analyzing device 300 of the third exemplary embodiment illustrated in Fig. 11, in that the analysis means 13 is replaced with an analysis means 43.

The analysis means 43 of this exemplary embodiment includes a model-breakage detection means 131, an abnormality determination means 132, an abnormality-factor extraction means 433, and a model-breakage storage means 434. As described above, this exemplary embodiment is different from the third exemplary embodiment in that the analysis means 43 further includes the abnormality-factor extraction means 433 and the model-breakage storage means 434.

The model-breakage storage means 434 stores model-breakage information generated by the model-breakage detection means 131. The processing of registering the model-breakage information in the model-breakage storage means 434 may be carried out, for example, when the abnormality determination means 132 determines that the state of a system is abnormal. In this case, the alarm condition described in the first exemplary embodiment can be used as an alarm condition for determining whether the state of the system is abnormal or normal.

When model-breakage information is newly added to the model-breakage storage means 434, the abnormality-factor extraction means 433 calculates an abnormality degree indicating the degree of an abnormality for each data item from the newly added model-breakage information. At least one data item is extracted in descending order of high abnormality degrees, each of the extracted data items is regarded as an abnormality factor candidate data item which is a data item as a candidate for an abnormality factor, and a manager and a system to be monitored are notified of an abnormality factor candidate data item group which is a set of the data items.

The manager can set an optional number, for example, as the number of data items confirmed when an abnormality occurs, at the number of data items contained in the abnormality factor candidate data item group, i.e., at the number of abnormality factor candidate data items of which notification is provided. The larger number of the abnormality factor candidate data items of which the notification is provided is preferred from the viewpoints of enhancing the possibility of finding the cause of a trouble and knowing the overall status of the trouble, and the smaller number of the abnormality factor candidate data items is preferred from the viewpoint of shortening an investigation time in a case in which a false report occurs.

For example, a value obtained by accumulating the numbers of data items contained in the regression equations of correlation models in which model breakages occur, in correlation models contained in an analysis model, for the corresponding data items, or the ratio between the value obtained by accumulating the numbers of the data items contained in the regression equations of the correlation models in which the model breakages occur and a value obtained by accumulating the numbers of data items contained in the regression equations of correlation models in which no model breakages occur can be used as the abnormality degrees of the data items.

Information required for the model-breakage information in this exemplary embodiment depends on an alarm condition and a method for calculating the abnormality degrees of data items. For example, when the alarm condition relates to the number of correlation models in which model breakages occur, the model-breakage information may be allowed to contain information capable of specifying the number of the correlation models in which the model breakages occur. When the method for calculating the abnormality degrees of data items employs a value obtained by accumulating the number of data items contained in regression equations in which model breakages occur for the corresponding data items, the model-breakage information may be allowed to contain information representing data items used in the regression equations of correlation models in which the model breakages occur, or information capable of specifying the correlation models in which the model breakages occur. When the method for calculating the abnormality degrees of data items employs a value (such as an accumulated value) relating to the number of data items contained in regression equations in which model breakages occur, and a value (such as an accumulated value) relating to the number of data items contained in regression equations in which no model breakages occur (for example, the ratio thereof), the model-breakage information may be allowed to contain information capable of specifying the regression equations in which the model breakages occur and the regression equations in which no model breakages occur.

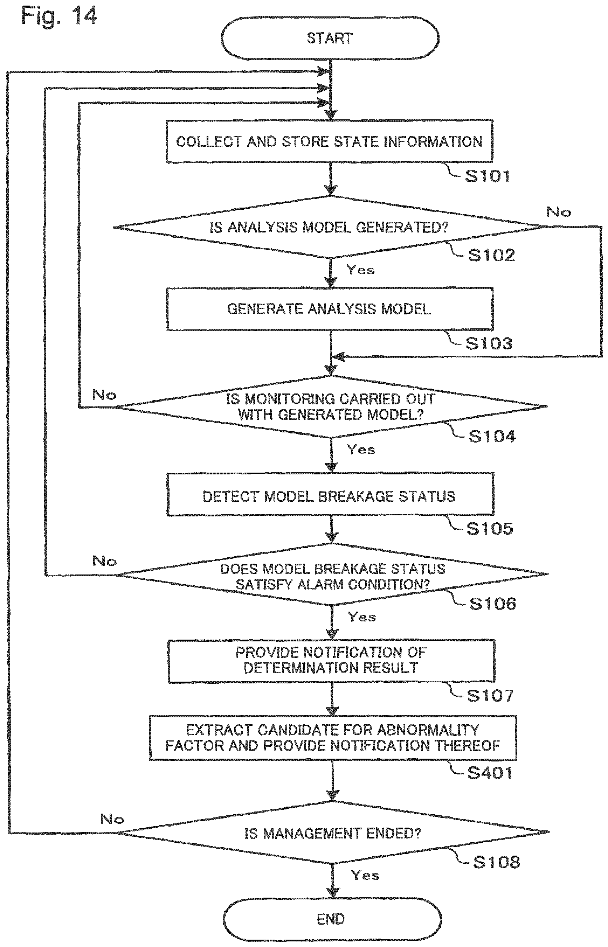

Next, the operations of the system-analyzing device 400 of this exemplary embodiment will be described. Fig. 14 is a flowchart representing an example of the operations of the system-analyzing device 400 of this exemplary embodiment. In the following description, the same operations as the operations represented in Fig. 8 are denoted by the same reference signs, and the descriptions thereof are omitted.

As shown in Fig. 14, when the abnormality determination means 132 determines that the state of a system is abnormal in step S107, the system-analyzing device 400 of this exemplary embodiment notifies a manager or the system to be monitored of the determination or model-breakage information, and stores the model-breakage information in the model-breakage storage means 434.

Then, the abnormality-factor extraction means 433 extracts one or more abnormality factor candidate data items based on the model-breakage information newly stored in the model-breakage storage means 434, and notifies the manager or the system to be monitored of information representing the group of the extracted abnormality factor candidate data items (step S401).

Next, a method for extracting the abnormality factor candidate data item group in this exemplary embodiment will be described with reference to a specific example. The following description is presented by taking, as an example, a case in which the abnormality degree of data items is set at the ratio between a value obtained by accumulating the number of data items contained in the regression equations of correlation models in which model breakages occur and a value obtained by accumulating the number of data items contained in the regression equations of correlation models in which no model breakages occur, in correlation models contained in an analysis model.

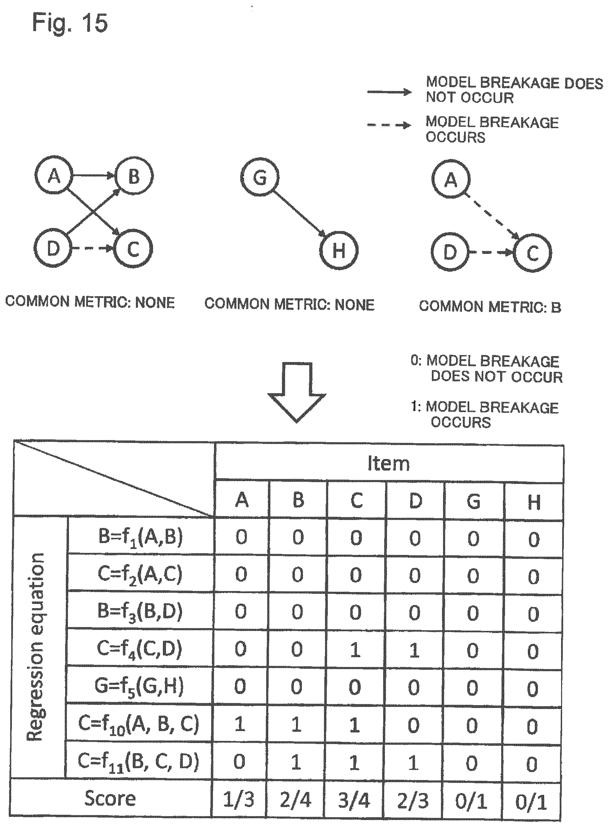

Fig. 15 is an explanatory diagram representing an example of the method for extracting an abnormality factor candidate data item group. In this example, an analysis model used by the system-analyzing device 400 includes seven correlation models. The regression equations of the seven correlation models included in the analysis model are $B = f_1(A, B)$, $C = f_2(A, C)$, $B = f_3(B, D)$, $C = f_4(C, D)$, $G = f_5(G, H)$, $C = f_{10}(A, B, C)$, and $C = f_{11}(B, C, D)$, respectively. The graph structure of the correlation model group included in the analysis model (structural diagram schematically representing the relationship of data items used in the correlation model group) is shown in the upper section of Fig. 15. In the graph structure, illustration of nodes corresponding to common data items is omitted. In the drawing, "common metric" represents a representative data item.

It is now assumed that a change associated with an abnormality occurs in a data item C, and model breakages occur in the correlation models having the regression equations $C = f_4(C, D)$, $C = f_{10}(A, B, C)$, and $C = f_{11}(B, C, D)$, in the correlation models of the analysis model. In this case, the abnormality degrees of data items A, B, C, D, G, and H are calculated as 1/3, 2/4, 3/4, 2/3, 0/1, and 0/1, respectively. The corresponding data items are sorted in descending order of the abnormality degrees thereof as follows: $C \rightarrow D \rightarrow B \rightarrow A \rightarrow \{G, H\}$. In this example, the possibilities of abnormality factors can be considered to be high to low in this order. If the number of abnormality factor candidate data items of which notification is provided is 2, the manager or the system to be monitored is notified of information representing the data items C and D (for example, the names of the data items) as information representing the abnormality factor candidate data item group.

As described above, according to this exemplary embodiment, the manager or the system to be monitored can narrow abnormality factors based on information of which notification is provided from the system-analyzing device 400.

In the above, an example in which the notification of the data item names as the information indicating representing the abnormality factor candidate data item group is provided is described. However, notification of not only the data item names but also abnormality degrees is preferable because priorities can be given to data items to be confirmed.

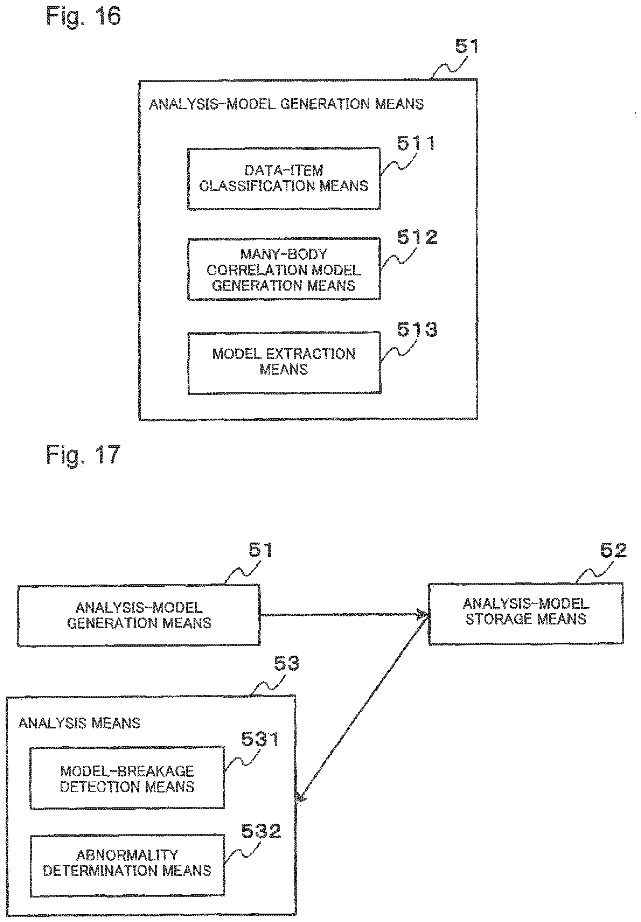

Fig. 16 is a block diagram illustrating the principal unit of the system-analyzing device according to the present invention. As illustrated in Fig. 16, the system-analyzing device according to the present invention includes analysis-model generation means 51 as a major configuration.

The analysis-model generation means 51 (for example, the analysis-model generation means 12 or the analysis-model generation means 32) is means that generates an analysis model for analyzing the state of a target system using state information which is a set of information on a plurality of kinds of data items in the target system. The analysis-model generation means 51 includes data-item classification means 511, a many-body correlation model generation means 512, and a model extraction means 513.

In the configuration illustrated in Fig. 16, the analysis model includes one or more many-body correlation models which are correlation models including at least a regression equation containing three or more data items and the permissible range of a prediction error for the regression equation.

The data-item classification means 511 (for example, a data-item classification means 1211) classifies a data item group included in state information into one or more groups. More specifically, for at least one group after the classification, when the fineness degrees of regression equations formulated using a first data item which is one data item optionally selected from data items included in the group, and a second data item which is one of data items included in a group in which the first data item is excluded and which is identical to the group of the first data item are calculated for all combinations of second data items possible for first data items, the data-item classification means 511 classifies the data items in such a way that at least one of the fineness degrees of the regression equations satisfies a predetermined fine model condition.

The many-body correlation model generation means 512 (for example, the many-body correlation model generation means 1212) chooses at least one representative data item from data items contained in each of the groups classified by the data-item classification means 511, formulates a regression equation for all combinations of two optional data items of data items contained in the group in which the chosen representative data item is excluded, the regression equation containing the two data items and the representative data item, calculates the permissible range of a prediction error for the regression equation, and the fineness degree of the regression equation, and generates a many-body correlation model including at least the formulated regression equation and the permissible range of the prediction error for the regression equation.

The model extraction means 513 (for example, model extraction means 122) extracts a many-body correlation model that satisfies a fine model condition for a many-body correlation model in which the fineness degree of a regression equation is predetermined, as a many-body correlation model intended to be contained in the analysis model, from the many-body correlation model group generated by the many-body correlation model generation means 512.

Because an analysis model including a many-body correlation model capable of calculating a prediction error can be generated with attention to a change unique to a data item while avoiding the problem of multicollinearity by including such a configuration, the state of a target system can be analyzed with high accuracy by analyzing the state of the system using such an analysis model even if the target system is complex or multicollinearity occurs between data items.

Fig. 17 is a block diagram representing another configuration example of the system-analyzing device according to the present invention. The system-analyzing device according to the present invention may be, for example, a configuration as illustrated in Fig. 17. The system-analyzing device illustrated in Fig. 17 includes an analysis-model storage means 52 and an analysis means 53 as well as the analysis-model generation means 51.

The analysis-model storage means 52 (for example, the analysis-model storage means 15) stores the information of an analysis model generated by the analysis-model generation means 51.

The analysis means 53 (for example, the analysis means 13 or the analysis means 43) is means that analyzes the state of the system using the analysis model stored in the analysis-model storage means when state information is newly acquired. The analysis means 53 includes a model-breakage detection means 531 and an abnormality determination means 532.

For each correlation model included in the analysis model represented by the information of the analysis model stored in the analysis-model storage means, the model-breakage detection means 531 (for example, the model-breakage detection means 131) detects the presence or absence of the occurrence of a model breakage which is a phenomenon that a predicted value of an objective variable in the regression equation of the correlation model is beyond the permissible range of a prediction error for the regression equation of the correlation model, using the newly collected state information.

The abnormality determination means 532 (for example, the abnormality determination means 132) determines whether the state of the system is abnormal or normal based on a detection result from the model-breakage detection means 531.

The state of the target system can be analyzed with high accuracy even if the target system is complex or multicollinearity occurs between data items by including such a configuration.

Some or all of the exemplary embodiments described above can also be described in the following supplementary notes, but are not limited to the following.

(Supplementary Note 1) A system-analyzing device, including an analysis-model generation means that generates an analysis model for analyzing a state of a target system using state information which is a set of information on a plurality of kinds of data items for the target system, wherein the analysis model includes at least one many-body correlation model which is a correlation model including at least: a regression equation containing three or more data items; and a permissible range of a prediction error for the regression equation; the analysis-model generation means includes: a data-item classification means that classifies a data item group contained in the state information into one or more groups; a many-body correlation model generation means that chooses at least one representative data item from data items contained in each of the groups classified by the data-item classification means according to the group, formulates a regression equation for all combinations of two optional data items of data items contained in the group in which the chosen representative data item is excluded, the regression equation containing the two data items and the representative data item, calculates a permissible range of a prediction error for the regression equation, and a fineness degree of the regression equation, and generates a many-body correlation model including at least the formulated regression equation and the permissible range of the prediction error for the regression equation; and a model extraction means that extracts a many-body correlation model that satisfies a fine model condition for a many-body correlation model in which a fineness degree of a regression equation is predetermined, as a many-body correlation model intended to be contained in the analysis model, from a many-body correlation model group generated by the many-body correlation model generation means; and when in at least one classified group, fineness degrees of regression equations formulated using a first data item which is one data item optionally selected from data items contained in the group, and a second data item which is one of data items contained in a group in which the first data item is excluded and which is identical to the group of the first data item are calculated for all combinations of second data items possible for the first data item, the data-item classification means classifies data items in such a way that at least one of the fineness degrees of the regression equation satisfies a predetermined fine model condition.

(Supplementary Note 2) An analysis-model generation program for allowing a computer to execute: data item classification processing in which when in at least one classified group, fineness degrees of regression equations formulated using a first data item which is one data item optionally selected from data items contained in the group, and a second data item which is one of data items contained in a group in which the first data item is excluded and which is identical to the group of the first data item are calculated for all combinations of second data items possible for the first data item, a data item group contained in state information which is a set of information on a plurality of kinds of data items for a target system is classified into one or more groups in such a way that at least one of the fineness degrees of the regression equations satisfies a predetermined fine model condition; and many-body correlation model generation processing in which at least one representative data item is chosen from data items contained in each of the classified groups using the state information according to the group, a regression equation is formulated for all combinations of two optional data items of data items contained in the group in which the chosen representative data item is excluded, the regression equation containing the two data items and the representative data item, a permissible range of a prediction error for the regression equation and a fineness degree of the regression equation are calculated, and a many-body correlation model including at least the formulated regression equation and the permissible range of the prediction error for the regression equation is generated.

The present invention is described above with reference to the exemplary embodiments and the examples. However, the present invention is not limited to the exemplary embodiments and examples described above. The constitutions and details of the present invention can be subjected to various modifications that can be understood by

those skilled in the art in the scope of the present invention.

This application claims priority based on Japanese Patent Application No. 2014-065120 filed on March 27, 2014.

**Industrial Applicability**

The present invention can be preferably applied for applications of detection of a trouble of a system and a trouble sign, and extraction of the factors thereof.

Reference Signs List

| 11 | State information collection means |
| 12, 32 | Analysis-model generation means |
| 121, 321 | Analysis model candidate generation means |
| 1211 | Data-item classification means |
| 1212 | Many-body correlation model generation means |
| 3213 | Cross-correlation model generation means |
| 122, 322 | Model extraction means |
| 13, 43 | Analysis means |
| 131 | Model-breakage detection means |
| 132 | Abnormality determination means |
| 433 | Abnormality-factor extraction means |
| 434 | Model-breakage storage means |
| 14 | State information storage means |
| 15 | Analysis-model storage means |
| 100, 300, 400 | System-analyzing device |
| 200 | Device to be monitored |
| 51 | Analysis-model generation means |
| 511 | Data-item classification means |
| 512 | Many-body correlation model generation means |
| 513 | Model extraction means |
| 52 | Analysis-model storage means |
| 53 | Analysis means |
| 531 | Model-breakage detection means |
| 532 | Abnormality determination means |
| 701A | Cross-correlation model group |
| 701B, 703B | Fine cross-correlation model group |
| 701C | Fine model condition |
| 701D, 703D | Graph structure |
| 701E, 703E1, 703E2 | Score |
| 703F1, 703F2 | Cluster |
| 702A | Many-body correlation model group |
| 702B | Fine many-body correlation model group |
| 702C | Fine model condition |

**Claims**

1. A system-analyzing device, comprising an analysis-model generation means (12; 32; 51) that generates an analysis model for analyzing a state of a target system using state information which is a set of information on a plurality of kinds of data items for the target system,
the analysis model including at least one many-body correlation model which is a correlation model including at least: a regression equation containing three or more data items; and a permissible range of a prediction error for the regression equation;
the analysis-model generation means (12; 32; 51) including:

a data-item classification means (1211; 511) that classifies a data item group contained in the state information into one or more groups;

a many-body correlation model generation means (1212; 512) that chooses at least one representative data item from data items contained in each of the groups classified by the data-item classification means (1211; 511) according to the group, formulates a regression equation for all combinations of two optional data items of data items contained in the group in which the chosen representative data item is excluded, the regression equation containing the two data items and the representative data item, calculates a permissible range of a prediction error for the regression equation, and a fineness degree of the regression equation, and generates a many-body correlation model including at least the formulated regression equation and the permissible range of the prediction error for the regression equation; and

a model extraction means (122; 322; 513) that extracts a many-body correlation model that satisfies a fine model condition for a many-body correlation model in which a fineness degree of a regression equation is predetermined, as a many-body correlation model intended to be contained in the analysis model, from a many-body correlation model group generated by the many-body correlation model generation means (1212; 512); and when in at least one classified group, fineness degrees of regression equations, formulated by use of a first data item which is one data item optionally selected from data items contained in the group and a second data item which is one of data items contained in a group in which the first data item is excluded and which is identical to the group of the first data item, are calculated by the data-item classification means for all combinations of second data items possible for the first data item, the data-item classification means classifying data items in such a way that at least one of the fineness degrees of the regression equation satisfies a predetermined fine model condition,

the system-analyzing device further comprising:

an analysis-model storage means (15; 52) that stores information of an analysis model generated by the analysis-model generation means (12; 32; 51); and

an analysis means (13; 43; 53) that analyzes a state of a system using the analysis model stored in the analysis-model storage means (15; 52) when state information is newly acquired,

wherein the analysis means (13; 43; 53) includes:

an model-breakage detection means (131; 531) that, for each correlation model contained in the analysis model represented by the information of the analysis model stored in the analysis-model storage means (15; 52), detects presence or absence of occurrence of a model breakage which is a phenomenon that a predicted value of an objective variable in a regression equation of the correlation model is beyond a permissible range of a prediction error for the regression equation of the correlation model, using the newly collected state information; and

an abnormality determination means (132; 532) that determines whether the state of the system is abnormal or normal based on a detection result from the model-breakage detection means (131; 531).

2. The system-analyzing device according to claim 1, wherein

the analysis means (43) includes an abnormality-factor extraction means (433) that extracts a data item which is a candidate for an abnormality factor based on a detection result from the model-breakage detection means (131) when an abnormality is determined by the abnormality determination means; and

the abnormality-factor extraction means (433) calculates an abnormality degree representing a degree of an abnormality according to each data item based on a status of occurrence of a model breakage according to each data item, represented as a result of detection by the model-breakage detection means (131), and extracts the data item which is the candidate for the abnormality factor based on the calculated abnormality degree according to each data item.

3. The system-analyzing device according to claim 1 or 2, wherein

the representative data item is chosen based on a statistic that is calculated using a fineness degree of each regression equation containing two optional data items in a group targeted for choice and is according to each data item belonging to the group.

4. The system-analyzing device according to claim 3, wherein

the statistic according to each data item is any one of an average value, median, minimum value, maximum value, and accumulated value of a fineness degree of a regression equation containing two optional data items, calculated using the fineness degree, in regression equations containing the data items in the group, for each data item belong to the group targeted for choosing the representative data item.

**5.** The system-analyzing device according to any one of claim 1 to claim 4, wherein
the representative data item is chosen based on earliness of appearance of a change point of information of each data item in a group targeted for choice, represented by state information corresponding to a predetermined period.

**6.** The system-analyzing device according to any one of claim 1 to claim 5, wherein
the analysis model further includes at least one cross-correlation model which is a correlation model containing at least a regression equation containing two data items and a permissible range of a prediction error for the regression equation;
the analysis-model generation means (32) includes a cross-correlation model generation means (3213) that formulates a regression equation containing two optional data items in a data item group contained in state information for all combinations of the two data items, calculates a permissible range of a prediction error for the regression equation and a fineness degree of the regression equation, and generates a cross-correlation model containing at least the formulated regression equation and the permissible range of the prediction error for the regression equation; and
the model extraction means (322) extracts a many-body correlation model that satisfies a fine model condition for a many-body correlation model in which a fineness degree of a regression equation is predetermined, as a many-body correlation model intended to be contained in the analysis model, from a many-body correlation model group generated by the many-body correlation model generation means (1212), and extracts a cross-correlation model that satisfies a fine model condition for a cross-correlation model in which a fineness degree of a regression equation is predetermined, as a cross-correlation model intended to be contained in the analysis model, from a cross-correlation model group generated by the cross-correlation model generation means (3213).

**7.** A system analysis method,
when in at least one classified group, fineness degrees of regression equations, formulated by use of a first data item which is one data item optionally selected from data items contained in the group and a second data item which is one of data items, contained in a group in which the first data item is excluded and which is identical to the group of the first data item, are calculated for all combinations of second data items possible for the first data item, by a data-item classification means (1211; 511), classify, into one or more groups from data item groups contained in state information which is a set of information on a plurality of kinds of data items for a target system in such a way that at least one of the fineness degrees of the regression equations satisfies a predetermined fine model condition;
by a many-body correlation model generation means (1212; 512), choosing at least one representative data item from data items contained in each of the classified groups using the state information according to the group, formulating a regression equation for all combinations of two optional data items of data items contained in the group in which the chosen representative data item is excluded, the regression equation containing the two data items and the representative data item, calculating a permissible range of a prediction error for the regression equation, and a fineness degree of the regression equation, and generating a many-body correlation model including at least the formulated regression equation and the permissible range of the prediction error for the regression equation;
by a model extraction means (122; 322; 513), extracting a many-body correlation model that satisfies a fine model condition for a many-body correlation model in which a fineness degree of a regression equation is predetermined, as a many-body correlation model intended to be contained in an analysis model, from a group of the generated many-body correlation model, and storing, in a predetermined storage device, information on the analysis model containing a group of the extracted many-body correlation model;
when state information is newly acquired, by a model-breakage detection means (131; 531), detecting presence or absence of occurrence of a model breakage which is a phenomenon in which a predicted value for an objective variable in a regression equation of each correlation model contained in the analysis model represented by the information on the analysis model stored in the predetermined storage device is beyond a permissible range of a prediction error for the regression equation of the correlation model, using the newly collected state information; and
by an abnormality determination means (132; 532), determining whether a state of a system is abnormal or normal, based on a result of detection by the model-breakage detection means (131; 531).

**8.** A system-analyzing program for allowing a computer to execute:

data-item classification processing in which when in at least one classified group, fineness degrees of regression equations formulated by use of a first data item which is one data item optionally selected from data items contained in the group and a second data item which is one of data items contained in a group in which the first data item is excluded and which is identical to the group of the first data item, are calculated for all combinations of second data items possible for the first data item, a data item group contained in state information which is a set of information on a plurality of kinds of data items for a target system is classified into one or more groups in such a way that at least one of the fineness degrees of the regression equations satisfies a predetermined fine model condition;

many-body correlation model generation processing in which at least one representative data item is chosen from data items contained in each of the classified groups using the state information according to the group, a regression equation is formulated for all combinations of two optional data items of data items contained in the group in which the chosen representative data item is excluded, the regression equation containing the two data items and the representative data item, a permissible range of a prediction error for the regression equation, and a fineness degree of the regression equation are calculated, and a many-body correlation model including at least the formulated regression equation and the permissible range of the prediction error for the regression equation is generated;

model extraction processing in which a many-body correlation model that satisfies a fine model condition for a many-body correlation model in which a fineness degree of a regression equation is predetermined is extracted as a many-body correlation model intended to be contained in an analysis model, from a group of the generated many-body correlation model;

processing in which information on the analysis model containing a group of the extracted many-body correlation model is stored in a predetermined storage device;

model-breakage detection processing in which when state information is newly acquired, presence or absence of occurrence of a model breakage which is a phenomenon in which a predicted value for an objective variable in a regression equation of each correlation model contained in the analysis model represented by the information on the analysis model stored in the predetermined storage device is beyond a permissible range of a prediction error for the regression equation of the correlation model is detected using the newly collected state information; and

abnormality determination processing in which it is determined whether a state of a system is abnormal or normal, based on a result of detection in the model-breakage detection processing.

## Patentansprüche

1. Systemanalysevorrichtung, umfassend eine Analysemodell-Erzeugungseinrichtung (12; 32; 51), die ein Analysemodell zum Analysieren eines Zustands eines Zielsystems unter Verwendung von Zustandsinformationen erzeugt, die ein Satz von Informationen über eine Vielzahl von Arten von Datenelementen für das Zielsystem sind,
wobei das Analysemodell mindestens ein Vielteilchen-Korrelationsmodell beinhaltet, das ein Korrelationsmodell ist, das mindestens Folgendes beinhaltet: eine Regressionsgleichung, die drei oder mehr Datenelemente enthält; und einen zulässigen Bereich eines Vorhersagefehlers für die Regressionsgleichung;
wobei die Analysemodell-Erzeugungseinrichtung (12; 32; 51) Folgendes beinhaltet:

ein Datenelemente-Klassifizierungsmittel (1211; 511), das eine in den Zustandsinformationen enthaltene Datenelementgruppe in eine oder mehrere Gruppen klassifiziert;
ein Mehrkörper-Korrelationsmodell-Erzeugungsmittel (1212; 512), das mindestens ein repräsentatives Datenelement aus Datenelementen auswählt, die in jeder der Gruppen enthalten sind, die durch das Datenelemente-Klassifizierungsmittel (1211; 511) gemäß der Gruppe klassifiziert wurden; eine Regressionsgleichung für alle Kombinationen von zwei optionalen Datenelementen von Datenelementen formuliert, die in der Gruppe enthalten sind, in der das ausgewählte repräsentative Datenelement ausgeschlossen ist, wobei die Regressionsgleichung die beiden Datenelemente und das repräsentative Datenelement enthält, einen zulässigen Bereich eines Vorhersagefehlers für die Regressionsgleichung und einen Feinheitsgrad der Regressionsgleichung berechnet und ein Mehrkörper-Korrelationsmodell erzeugt, das mindestens die formulierte Regressionsgleichung und den zulässigen Bereich des Vorhersagefehlers für die Regressionsgleichung beinhaltet; und
eine Modellextraktionseinrichtung (122; 322; 513), die ein Vielteilchen-Korrelationsmodell extrahiert, das eine Feinmodellbedingung für ein Vielteilchen-Korrelationsmodell erfüllt, in dem ein Feinheitsgrad einer Regressionsgleichung als Vielteilchen-Korrelationsmodell, das dazu bestimmt ist, in dem Analysemodell enthalten zu sein, aus einer Vielteilchen-Korrelationsmodellgruppe vorgegeben ist, die durch die Vielteilchen-Korrelationsmodellgenerationseinrichtung (1212; 512) erzeugt wird; und
wenn in mindestens einer klassifizierten Gruppe Feinheitsgrade von Regressionsgleichungen, formuliert unter Verwendung eines ersten Datenelements, das ein Datenelement ist, das optional aus in der Gruppe enthaltenen Datenelementen ausgewählt ist, und eines zweiten Datenelements, das eines von Datenelementen ist, die in einer Gruppe enthalten sind, in der das erste Datenelement ausgeschlossen ist, und das identisch mit der Gruppe des ersten Datenelements ist, durch die Datenelemente-Klassifizierungsmittel für alle Kombinationen von für das erste Datenelement möglichen zweiten Datenelementen berechnet werden, wobei die Datenelemente-Klassifizierungsmittel Datenelemente so klassifizieren, dass mindestens einer der Feinheitsgrade der Regressionsgleichung eine vorbestimmte Feinmodellbedingung erfüllt,
wobei die Systemanalysevorrichtung ferner umfasst:

eine Speichereinrichtung (15; 52) für Analysemodelle, die Informationen eines Analysemodells speichert, das durch die Erzeugungseinrichtung (12; 32; 51) für Analysemodelle erzeugt wird; und
ein Analysemittel (13; 43; 53), das einen Zustand eines Systems unter Verwendung des in dem Analysemodellspeichermittel (15; 52) gespeicherten Analysemodells analysiert, wenn Zustandsinformationen neu erfasst werden,
wobei die Analysemittel (13; 43; 53) beinhalten:

ein Modellbrucherfassungsmittel (131; 531), das für jedes Korrelationsmodell, das in dem Analysemodell enthalten ist, das durch die Informationen des Analysemodells, die in dem Analysemodellspeichermittel (15; 52) gespeichert sind, dargestellt wird, das Vorhandensein oder Nichtvorhandensein eines Modellbruchs erfasst, der ein Phänomen ist, dass ein vorhergesagter Wert einer Zielvariablen in einer Regressionsgleichung des Korrelationsmodells außerhalb eines zulässigen Bereichs eines Vorhersagefehlers für die Regressionsgleichung des Korrelationsmodells liegt, unter Verwendung der neu gesammelten Zustandsinformationen; und
eine Anomalie-Bestimmungseinrichtung (132; 532), die bestimmt, ob der Zustand des Systems anormal oder normal ist, basierend auf einem Erfassungsergebnis der Modellbruch-Erfassungseinrichtung (131; 531).

2. Systemanalysevorrichtung nach Anspruch 1, wobei
das Analysemittel (43) ein Anomalie-Faktor-Extraktionsmittel (433) beinhaltet, das ein Datenelement extrahiert, das ein Kandidat für einen Anomaliefaktor basierend auf einem Detektionsergebnis aus dem Modellbruch-Erfassungsmittel (131) ist, wenn eine Anomalie durch das Anomalie-Bestimmungsmittel bestimmt wird; und
das Anomalie-Faktor-Extraktionsmittel (433) einen Anomaliegrad berechnet, der einen Grad einer Anomalie gemäß jedem Datenelement basierend auf einem Status des Auftretens eines Modellbruchs gemäß jedem Datenelement darstellt, der als Ergebnis der Erkennung durch das Modellbruch-Erfassungsmittel (131) dargestellt wird, und das Datenelement extrahiert, das der Kandidat für den Anomaliefaktor basierend auf dem berechneten Anomaliegrad gemäß jedem Datenelement ist.

3. Systemanalysevorrichtung nach Anspruch 1 oder 2, wobei
das repräsentative Datenelement basierend auf einer Statistik ausgewählt wird, die unter Verwendung eines Feinheitsgrades jeder Regressionsgleichung berechnet wird, die zwei optionale Datenelemente in einer Gruppe enthält, die zur Auswahl steht, und entsprechend jedem Datenelement, das zur Gruppe gehört.

4. Systemanalysevorrichtung nach Anspruch 3, wobei
die Statistik gemäß jedem Datenelement einer Durchschnittswert, Median, Minimalwert, Maximalwert und kumulierter Wert eines Feinheitsgrades einer Regressionsgleichung mit zwei optionalen Datenelementen, berechnet aus dem Feinheitsgrad, in Regressionsgleichungen mit den Datenelementen in der Gruppe ist, für jedes Datenelement zu der Gruppe gehören, die für die Auswahl des repräsentativen Datenelements vorgesehen ist.

5. Systemanalysevorrichtung nach einem der Ansprüche 1 bis 4, wobei
das repräsentative Datenelement basierend auf der Frühzeitigkeit des Auftretens eines Änderungspunktes der Informationen jedes Datenelements in einer Gruppe ausgewählt wird, die zur Auswahl steht, dargestellt durch Zustandsinformationen, die einem vorbestimmten Zeitraum entsprechen.

6. Systemanalysevorrichtung nach einem der Ansprüche 1 bis 5, worin
das Analysemodell ferner mindestens ein Kreuzkorrelationsmodell beinhaltet, das ein Korrelationsmodell ist, das mindestens eine Regressionsgleichung mit zwei Datenelementen und einem zulässigen Bereich eines Vorhersagefehlers für die Regressionsgleichung enthält;
die Analysemodell-Erzeugungseinrichtung (32) eine Kreuzkorrelationsmodell-Erzeugungseinrichtung (3213) beinhaltet, die eine Regressionsgleichung formuliert, die zwei optionale Datenelemente in einer Datenelementgruppe enthält, die in Zustandsinformationen für alle Kombinationen der beiden Datenelemente enthalten ist, einen zulässigen Bereich eines Vorhersagefehlers für die Regressionsgleichung und einen Feinheitsgrad der Regressionsgleichung berechnet und ein Kreuzkorrelationsmodell erzeugt, das mindestens die formulierte Regressionsgleichung und den zulässigen Bereich des Vorhersagefehlers für die Regressionsgleichung enthält; und

die Modellextraktionseinrichtung (322) ein Vielteilchen-Korrelationsmodell extrahiert, das eine Feinmodellbedingung für ein Vielteilchen-Korrelationsmodell erfüllt, in dem ein Feinheitsgrad einer Regressionsgleichung als Vielteilchen-Korrelationsmodell, das dazu bestimmt ist, im Analysemodell enthalten zu sein, aus einer Vielteilchen-Korrelationsmodellgruppe vorgegeben ist, die durch die Vielteilchen-Korrelationsmodellgenerationseinrichtung (1212) erzeugt wird, und ein Kreuzkorrelationsmodell erxtrahiert, das eine Feinmodellbedingung für ein Kreuzkorrelationsmodell erfüllt, in dem ein Feinheitsgrad einer Regressionsgleichung als Kreuzkorrelationsmodell, das dazu bestimmt ist, im Analysemodell enthalten zu sein, aus einer Kreuzkorrelationsmodellgruppe vorgegeben ist, die von den Erzeugungsmitteln (3213) für Kreuzkorrelationsmodelle erzeugt wird.

7. Eine Systemanalyseverfahren,
wenn in mindestens einer klassifizierten Gruppe Feinheitsgrade von Regressionsgleichungen, formuliert unter Verwendung eines ersten Datenelements, das ein Datenelement ist, das optional aus in der Gruppe enthaltenen Datenelementen ausgewählt ist, und eines zweiten Datenelements, das eines von Datenelementen ist, die in einer Gruppe enthalten sind, in der das erste Datenelement ausgeschlossen ist und das identisch mit der Gruppe des ersten Datenelements ist, für alle Kombinationen von zweiten Datenelementen berechnet werden, die für das erste Datenelement möglich sind, durch eine Datenelementklassifikationseinrichtung (1211; 511), klassifizieren, in eine oder mehrere Gruppen aus Datenelementgruppen, die in Zustandsinformationen enthalten sind, die ein Satz von Informationen über eine Vielzahl von Arten von Datenelementen für ein Zielsystem sind, derart, dass mindestens einer der Feinheitsgrade der Regressionsgleichungen eine vorbestimmte Feinmodellbedingung erfüllt;
durch ein Mehrkörper-Korrelationsmodell-Erzeugungsmittel (1212; 512), Auswählen mindestens eines repräsentativen Datenelements aus Datenelementen, die in jeder der klassifizierten Gruppen enthalten sind, unter Verwendung der Zustandsinformationen gemäß der Gruppe, Formulieren einer Regressionsgleichung für alle Kombinationen von zwei optionalen Datenelementen von Datenelementen, die in der Gruppe enthalten sind, in der das ausgewählte repräsentative Datenelement ausgeschlossen ist, die Regressionsgleichung, die die beiden Datenelemente und das repräsentative Datenelement enthält, Berechnen eines zulässigen Bereichs eines Vorhersagefehlers für die Regressionsgleichung und eines Feinheitsgrades der Regressionsgleichung und Erzeugen eines Vielteilchen-Korrelationsmodells, das mindestens die formulierte Regressionsgleichung und den zulässigen Bereich des Vorhersagefehlers für die Regressionsgleichung beinhaltet;
durch ein Modellextraktionsmittel (122; 322; 513), Extrahieren eines Vielteilchen-Korrelationsmodells, das eine Feinmodellbedingung für ein Vielteilchen-Korrelationsmodell erfüllt, in dem ein Feinheitsgrad einer Regressionsgleichung vorgegeben ist, als Vielteilchen-Korrelationsmodell, das dazu bestimmt ist, in einem Analysemodell enthalten zu sein, aus einer Gruppe des erzeugten Vielteilchen-Korrelationsmodells und Speichern von Informationen über das Analysemodell, das eine Gruppe des extrahierten Vielteilchen-Korrelationsmodells enthält, in einer vorbestimmten Speichervorrichtung;
wenn Zustandsinformationen neu erfasst werden, durch ein Modellbrucherfassungsmittel (131; 531), das das Vorhandensein oder Nichtvorhandensein eines Modellbruchs erfasst, der ein Phänomen ist, bei dem ein vorhergesagter Wert für eine Zielvariable in einer Regressionsgleichung jedes Korrelationsmodells, das in dem Analysemodell enthalten ist, das durch die in der vorbestimmten Speichervorrichtung gespeicherten Informationen über das Analysemodell dargestellt wird, außerhalb eines zulässigen Bereichs eines Vorhersagefehlers für die Regressionsgleichung des Korrelationsmodells unter Verwendung der neu gesammelten Zustandsinformationen liegt; und
durch ein Anomalie-Bestimmungsmittel (132; 532), das bestimmt, ob ein Zustand eines Systems anormal oder normal ist, basierend auf einem Ergebnis der Erkennung durch das Modellbruch-Erfassungsmittel (131; 531).

8. Ein Systemanalyseprogramm, um einem Computer zu erlauben, auszuführen:

Datenelementklassifikationsverarbeitung, bei der, wenn in mindestens einer klassifizierten Gruppe, Feinheitsgrade von Regressionsgleichungen formuliert unter Verwendung eines ersten Datenelements, das ein Datenelement ist, das optional aus in der Gruppe enthaltenen Datenelementen ausgewählt ist, und eines zweiten Datenelements, das eines von Datenelementen ist, die in einer Gruppe enthalten sind, in der das erste Datenelement ausgeschlossen ist und das identisch mit der Gruppe des ersten Datenelements ist, für alle Kombinationen von für das erste Datenelement möglichen zweiten Datenelementen berechnet werden, wird eine in Zustandsinformationen enthaltene Datenelementgruppe, die ein Satz von Informationen über eine Vielzahl von Arten von Datenelementen für ein Zielsystem ist, in eine oder mehrere Gruppen derart klassifiziert, dass mindestens einer der Feinheitsgrade der Regressionsgleichungen eine vorgegebene Feinmodellbedingung erfüllt;
Mehrkörper-Korrelationsmodell-Erzeugungsverarbeitung, bei der mindestens ein repräsentatives Datenelement aus Datenelementen ausgewählt wird, die in jeder der klassifizierten Gruppen enthalten sind, unter Verwendung der Zustandsinformationen gemäß der Gruppe, eine Regressionsgleichung für alle Kombinationen von zwei optionalen Datenelementen von Datenelementen formuliert wird, die in der Gruppe enthalten sind, in der das ausgewählte repräsentative Datenelement ausgeschlossen ist, die Regressionsgleichung, die die beiden Datenelemente und das repräsentative Datenelement enthält, ein zulässiger Bereich eines Vorhersagefehlers für die Regressionsgleichung und ein Feinheitsgrad der Regressionsgleichung berechnet werden und ein Vielteilchen-Korrelationsmodell erzeugt wird, das mindestens die formulierte Regressionsgleichung und den zulässigen Bereich des Vorhersagefehlers für die Regressionsgleichung beinhaltet;

Modell-Extraktionsverarbeitung, bei der ein Vielteilchen-Korrelationsmodell, das eine Feinmodellbedingung für ein Vielteilchen-Korrelationsmodell erfüllt, in dem ein Feinheitsgrad einer Regressionsgleichung vorgegeben ist, als Vielteilchen-Korrelationsmodell extrahiert wird, das in einem Analysemodell enthalten sein soll, aus einer Gruppe des erzeugten Vielteilchen-Korrelationsmodells;

Verarbeitung, bei der Informationen über das Analysemodell, das eine Gruppe des extrahierten Mehrkörper-Korrelationsmodells enthält, in einer vorbestimmten Speichervorrichtung gespeichert werden;

Modellbrucherkennungsverarbeitung, bei der bei einer Neuerfassung von Zustandsinformationen das Vorhandensein oder Nichtvorhandensein eines Modellbruchs, der ein Phänomen ist, bei dem ein vorhergesagter Wert für eine Zielvariable in einer Regressionsgleichung jedes Korrelationsmodells, das in dem Analysemodell enthalten ist, das durch die in der vorbestimmten Speichervorrichtung gespeicherten Informationen über das Analysemodell repräsentiert wird, außerhalb eines zulässigen Bereichs eines Vorhersagefehlers für die Regressionsgleichung des Korrelationsmodells liegt, unter Verwendung der neu gesammelten Zustandsinformationen erkannt wird; und

Anomaliebestimmungsverarbeitung, bei der bestimmt wird, ob ein Zustand eines Systems anormal oder normal ist, basierend auf einem Ergebnis der Erkennung in der Modellbruchbestimmungsverarbeitung.

## Revendications

**1.** Dispositif d'analyse de système, comprenant des moyens de génération de modèle d'analyse (12; 32; 51) qui génèrent un modèle d'analyse pour analyser un état d'un système cible à l'aide d'informations d'état qui sont un ensemble d'informations sur une pluralité de types d'éléments de données pour le système cible,

le modèle d'analyse incluant au moins un modèle de corrélation à corps multiples qui est un modèle de corrélation incluant au moins : une équation de régression contenant trois éléments de données ou plus ; et une plage admissible d'une erreur de prédiction pour l'équation de régression ;

les moyens de génération de modèle d'analyse (12 ; 32 ; 51) incluant :

des moyens de classement d'élément de données (1211 ; 511) qui classent un groupe d'éléments de données contenus dans les informations d'état en un ou plusieurs groupes ;

des moyens de génération de modèle de corrélation à corps multiples (1212 ; 512) qui choisissent au moins un élément de données représentatif parmi les éléments de données contenus dans chacun des groupes classés par les moyens de classement d'élément de données (1211 ; 511) en fonction du groupe, formulent une équation de régression pour toutes les combinaisons de deux éléments de données facultatifs parmi les éléments de données contenus dans le groupe dont l'élément de données représentatif choisi est exclu, l'équation de régression contenant les deux éléments de données et l'élément de données représentatif, calculent une plage admissible d'une erreur de prédiction pour l'équation de régression, et un degré de finesse de l'équation de régression, et génèrent un modèle de corrélation à corps multiples incluant au moins l'équation de régression formulée et la plage admissible de l'erreur de prédiction pour l'équation de régression ; et

des moyens d'extraction de modèle (122 ; 322 ; 513) qui extraient un modèle de corrélation à corps multiples qui satisfait une condition de modèle fin pour un modèle de corrélation à corps multiples dans laquelle un degré de finesse d'une équation de régression est prédéterminé, comme modèle de corrélation à corps multiples destiné à être contenu dans le modèle d'analyse, à partir d'un groupe de modèles de corrélation à corps multiples générés par les moyens de génération de modèle de corrélation à corps multiples (1212; 512) ; et

lorsque dans au moins un groupe classé, des degrés de finesse d'équations de régression, formulées à l'aide d'un premier élément de données qui est un élément de données facultativement sélectionné parmi des éléments de données contenus dans le groupe et d'un deuxième élément de données qui est l'un des éléments de données contenus dans un groupe dont le premier élément de données est exclu et qui est identique au groupe du premier élément de données, sont calculés par les moyens de classement d'élément de données pour toutes les combinaisons de deuxièmes éléments de données possibles pour le premier élément de données, les moyens de classement d'élément de données classant les éléments de données de telle sorte qu'au moins un des degrés de finesse de l'équation de régression satisfasse une condition de modèle fin prédéterminée, le dispositif d'analyse de système comprenant en outre :

des moyens de stockage de modèle d'analyse (15 ; 12) qui stockent des informations d'un modèle d'analyse généré par les moyens de génération de modèle d'analyse (12 ; 32 ; 51) ; et

des moyens d'analyse (13 ; 43 ; 53) qui analysent un état d'un système à l'aide du modèle d'analyse stocké dans les moyens de stockage de modèle d'analyse (15 ; 12) lorsque des informations d'état sont nouvellement acquises,

dans lequel les moyens d'analyse (13 ; 43 ; 53) incluent :

des moyens de détection de rupture de modèle (131; 531) qui, pour chaque modèle de corrélation contenu dans le modèle d'analyse représenté par les informations du modèle d'analyse stocké dans les moyens de stockage de modèle d'analyse (15 ; 52), détectent la présence ou l'absence d'occurrence d'une rupture de modèle qui est un phénomène dans lequel une valeur prédite d'une variable objective dans une équation de régression du modèle de corrélation se situe au-delà d'une plage admissible d'une erreur de prédiction pour l'équation de régression du modèle de corrélation, à l'aide des informations d'état nouvellement collectées ; et

des moyens de détermination d'anomalie (132; 532) qui déterminent si l'état du système est anormal ou normal en fonction d'un résultat de détection provenant des moyens de détection de rupture de modèle (131 ; 531).

2. Dispositif d'analyse de système selon la revendication 1, dans lequel

les moyens d'analyse (43) incluent des moyens d'extraction de facteur d'anomalie (433) qui extraient un élément de données qui est candidat pour un facteur d'anomalie en fonction d'un résultat de détection provenant des moyens de détection de rupture de modèle (131) lorsqu'une anomalie est déterminée par les moyens de détermination d'anomalie ; et

les moyens d'extraction de facteur d'anomalie (433) calculent un degré d'anomalie représentant un degré d'une anomalie en fonction de chaque élément de données sur la base d'un état d'occurrence d'une rupture de modèle en fonction de chaque élément de données, représenté comme un résultat de détection par les moyens de détection de rupture de modèle (131), et extraient l'élément de données qui est candidat pour le facteur d'anomalie sur la base du degré d'anomalie calculé en fonction de chaque élément de données.

3. Dispositif d'analyse de système selon les revendications 1 ou 2, dans lequel

l'élément de données représentatif est choisi sur la base d'une statistique qui est calculée à l'aide d'un degré de finesse de chaque équation de régression contenant deux éléments de données facultatifs dans un groupe ciblé pour un choix et est fonction de chaque élément de données appartenant au groupe.

4. Dispositif d'analyse de système selon la revendication 3, dans lequel

la statistique selon chaque élément de données est l'une quelconque parmi une valeur moyenne, une médiane, une valeur minimale, une valeur maximale et une valeur cumulée d'un degré de finesse d'une équation de régression contenant deux éléments de données facultatifs, calculée à l'aide du degré de finesse, dans des équations de régression contenant les éléments de données du groupe, pour chaque élément de données appartenant au groupe ciblé pour le choix de l'élément de données représentatif.

5. Dispositif d'analyse de système selon l'une quelconque de la revendication 1 à la revendication 4, dans lequel

l'élément de données représentatif est choisi sur la base de la précocité d'apparition d'un point de changement d'informations de chaque élément de données dans un groupe ciblé pour un choix, représenté par des informations d'état correspondant à une période prédéterminée.

6. Dispositif d'analyse de système selon l'une quelconque de la revendication 1 à la revendication 5, dans lequel

le modèle d'analyse inclut en outre au moins un modèle de corrélation croisée qui est un modèle de corrélation contenant au moins une équation de régression contenant deux éléments de données et une plage admissible d'une erreur de prédiction pour l'équation de régression ;

les moyens de génération de modèle d'analyse (32) incluent des moyens de génération de modèle de corrélation croisée (3213) qui formulent une équation de régression contenant deux éléments de données facultatifs d'un groupe d'éléments de données contenus dans des informations d'état pour toutes les combinaisons des deux éléments de données, calculent une plage admissible d'une erreur de prédiction pour l'équation de régression et un degré de finesse de l'équation de régression, et génèrent un modèle de corrélation croisée contenant au moins l'équation de régression formulée et la plage admissible de l'erreur de prédiction pour l'équation de régression ; et

les moyens d'extraction de modèle (322) extraient un modèle de corrélation à corps multiples qui satisfait une condition de modèle fin pour un modèle de corrélation à corps multiples dans laquelle un degré de finesse d'une équation de régression est prédéterminé, comme modèle de corrélation à corps multiples destiné à être contenu dans le modèle d'analyse, à partir d'un groupe de modèles de corrélation à corps multiples générés par les moyens de génération de modèle de corrélation à corps multiples (1212), et extraient un modèle de corrélation croisée qui satisfait une condition de modèle fin pour un modèle de corrélation croisée dans laquelle un degré de finesse d'une équation de régression est prédéterminé, comme modèle de corrélation croisée destiné à être contenu dans le modèle d'analyse, à partir d'un groupe de modèles de corrélation croisée générés par les moyens de génération de modèle de corrélation croisée (3213).

7. Procédé d'analyse de système,
lorsque dans au moins un groupe classé, des degrés de finesse d'équations de régression, formulées à l'aide d'un premier élément de données qui est un élément de données facultativement sélectionné parmi des éléments de données contenus dans le groupe et d'un deuxième élément de données qui est l'un parmi des éléments de données contenus dans un groupe dont le premier élément de données est exclu et qui est identique au groupe du premier élément de données, sont calculés pour toutes les combinaisons de deuxièmes éléments de données possibles pour le premier élément de données, par des moyens de classement d'élément de données (1211 ; 511), classent, en un ou plusieurs groupes parmi des groupes d'éléments de données contenus dans des informations d'état qui sont un ensemble d'informations sur une pluralité de types d'éléments de données pour un système cible de telle sorte qu'au moins un des degrés de finesse des équations de régression satisfasse une condition de modèle fin prédéterminée ;
par des moyens de génération de modèle de corrélation à corps multiples (1212 ; 512), le choix d'au moins un élément de données représentatif parmi des éléments de données contenus dans chacun des groupes classés à l'aide des informations d'état en fonction du groupe, la formulation d'une équation de régression pour toutes les combinaisons de deux éléments de données facultatifs parmi les éléments de données contenus dans le groupe dont l'élément de données représentatif choisi est exclu, l'équation de régression contenant les deux éléments de données et l'élément de données représentatif, le calcul d'une plage admissible d'une erreur de prédiction pour l'équation de régression et d'un degré de finesse de l'équation de régression, et la génération d'un modèle de corrélation à corps multiples incluant au moins l'équation de régression formulée et la plage admissible de l'erreur de prédiction pour l'équation de régression ;
par des moyens d'extraction de modèle (122 ; 322 ; 513), l'extraction d'un modèle de corrélation à corps multiples qui satisfait une condition de modèle fin pour un modèle de corrélation à corps multiples dans laquelle un degré de finesse d'une équation de régression est prédéterminé, comme modèle de corrélation à corps multiples destiné à être contenu dans un modèle d'analyse, à partir d'un groupe du modèle de corrélation à corps multiples généré, et le stockage, dans un dispositif de stockage prédéterminé, d'informations sur le modèle d'analyse contenant un groupe du modèle de corrélation à corps multiples extrait ;
lorsque des informations d'état sont nouvellement acquises, par des moyens de détection de rupture de modèle (131 ; 531), la détection de la présence ou de l'absence d'occurrence d'une rupture de modèle qui est un phénomène dans lequel une valeur prédite pour une variable objective dans une équation de régression de chaque modèle de corrélation contenu dans le modèle d'analyse représenté par les informations sur le modèle d'analyse stockées dans le dispositif de stockage prédéterminé se situe au-delà d'une plage admissible d'une erreur de prédiction pour l'équation de régression du modèle de corrélation, à l'aide des informations d'état nouvellement collectées ; et
par des moyens de détermination d'anomalie (132 ; 532), le fait de déterminer si un état d'un système est anormal ou normal, en fonction d'un résultat de détection par les moyens de détection de rupture de modèle (131 ; 531).

8. Programme d'analyse de système pour permettre à un ordinateur d'exécuter :

un traitement de classement d'élément de données dans lequel lorsque dans au moins un groupe classé, des degrés de finesse d'équations de régression formulées à l'aide d'un premier élément de données qui est un élément de données facultativement sélectionné parmi des éléments de données contenus dans le groupe et d'un deuxième élément de données qui est l'un des éléments de données contenus dans un groupe dont le premier élément de données est exclu et qui est identique au groupe du premier élément de données, sont calculés pour toutes les combinaisons de deuxièmes éléments de données possibles pour le premier élément de données, un groupe d'éléments de données contenus dans des informations d'état qui sont un ensemble d'informations sur une pluralité de types d'éléments de données pour un système cible est classé en un ou plusieurs groupes de telle sorte qu'au moins un des degrés de finesse des équations de régression satisfasse une condition de modèle fin prédéterminée ;
un traitement de génération de modèle de corrélation à corps multiples dans lequel au moins un élément de données représentatif est choisi parmi des éléments de données contenus dans chacun des groupes classés à l'aide des informations d'état en fonction du groupe, une équation de régression est formulée pour toutes les combinaisons de deux éléments de données facultatifs parmi des éléments de données contenus dans le groupe dont l'élément de données représentatif choisi est exclu, l'équation de régression contenant les deux éléments de données et l'élément de données représentatif, une plage admissible d'une erreur de prédiction pour l'équation de régression et un degré de finesse de l'équation de régression sont calculés, et un modèle de corrélation à corps multiples incluant au moins l'équation de régression formulée et la plage admissible de l'erreur de prédiction pour l'équation de régression est généré ;

un traitement d'extraction de modèle dans lequel un modèle de corrélation à corps multiples qui satisfait une condition de modèle fin pour un modèle de corrélation à corps multiples dans laquelle un degré de finesse d'une équation de régression est prédéterminé est extrait comme modèle de corrélation à corps multiples destiné à être contenu dans un modèle d'analyse, à partir d'un groupe du modèle de corrélation à corps multiples généré ;

un traitement dans lequel des informations sur le modèle d'analyse contenant un groupe du modèle de corrélation à corps multiples extrait sont stockées dans un dispositif de stockage prédéterminé ;

un traitement de détection de rupture de modèle dans lequel lorsque des informations d'état sont nouvellement acquises, la présence ou l'absence d'occurrence d'une rupture de modèle qui est un phénomène dans lequel une valeur prédite pour une variable objective dans une équation de régression de chaque modèle de corrélation contenu dans le modèle d'analyse représenté par les informations sur le modèle d'analyse stockées dans le dispositif de stockage prédéterminé se situe au-delà d'une plage admissible d'une erreur de prédiction pour l'équation de régression du modèle de corrélation est détectée à l'aide des informations d'état nouvellement collectées ; et

un traitement de détermination d'anomalie dans lequel il est déterminé qu'un état d'un système est anormal ou normal, en fonction d'un résultat de détection du traitement de détection de rupture de modèle.

## Fig. 1

## Fig. 2

701A

| Item 1 | Item 2 | Regression equation | F |
|---|---|---|---|
| A | B | $B = f_1(A,B)$ | 0.8 |
| A | C | $C = f_2(A,C)$ | 0.8 |
| B | D | $B = f_3(B,D)$ | 0.9 |
| C | D | $C = f_4(C,D)$ | 0.7 |
| G | H | $G = f_5(G,H)$ | 0.5 |

701C

$F > 0.6$

701B

| Item 1 | Item 2 | Regression equation | F |
|---|---|---|---|
| A | B | $B = f_1(A,B)$ | 0.8 |
| A | C | $C = f_2(A,C)$ | 0.8 |
| B | D | $B = f_3(B,D)$ | 0.9 |
| C | D | $C = f_4(C,D)$ | 0.7 |

Fig. 3

702A

| Item 1 | Item 2 | Representative Item | Regression equation | F |
|--------|--------|---------------------|---------------------|---|
| A | C | B | $C=f_{10}(A, B, C)$ | 0.9 |
| C | D | B | $C=f_{11}(B, C, D)$ | 0.8 |

702C

$F > 0.6$

702B

| Item 1 | Item 2 | Representative Item | Regression equation | F |
|--------|--------|---------------------|---------------------|---|
| A | C | B | $C=f_{10}(A, B, C)$ | 0.9 |
| C | D | B | $C=f_{11}(B, C, D)$ | 0.8 |

## Fig. 4

701B

| Item 1 | Item 2 | Regression equation | F |
|--------|--------|---------------------|-----|
| A | B | $B=f_1(A,B)$ | 0.8 |
| A | C | $C=f_2(A,C)$ | 0.8 |
| B | D | $B=f_3(B,D)$ | 0.9 |
| C | D | $C=f_4(C,D)$ | 0.7 |

701D

A → B

D → C

○ :NODE

Fig. 5

701D

```
  (A) ──→ (B)
    ╲   ╱
     ╲ ╱
      ╳
     ╱ ╲
  (D) ──→ (C)
```

701E

| Item | Score |
|------|-------|
| A | 1.6 |
| B | 1.7 |
| C | 1.5 |
| D | 1.6 |

Item B

Fig. 6

703B

| Item 1 | Item 2 | Regression equation | F |
|--------|--------|---------------------|---|
| A | B | $B=f_1(A,B)$ | 0.8 |
| A | C | $C=f_2(A,C)$ | 0.8 |
| B | D | $B=f_3(B,D)$ | 0.9 |
| C | D | $C=f_4(C,D)$ | 0.7 |
| K | L | $K=f_{20}(K,L)$ | 0.7 |
| K | M | $K=f_{21}(K,M)$ | 0.7 |

703D

703F1

703F2

Fig. 7

703D

703F1

703F2

| Item | Score |
|------|-------|
| A | 1.6 |
| B | 1.7 |
| C | 1.5 |
| D | 1.6 |

703E1

| Item | Score |
|------|-------|
| K | 1.4 |
| L | 0.7 |
| M | 0.7 |

703E2

Item B

Item K

Fig. 8

```
                    ┌─────────────┐
                    │    START    │
                    └─────────────┘
                           │
                           ▼
          ┌──────────────────────────────────────┐
          │  COLLECT AND STORE STATE INFORMATION  │
          └──────────────────────────────────────┘
                                            └─ S101
                           │
                           ▼
          ◇ IS ANALYSIS MODEL GENERATED? ◇ ──── No ──┐
                                          └─ S102      │
                           │ Yes                       │
                           ▼                           │
          ┌──────────────────────────────┐            │
          │     GENERATE ANALYSIS MODEL   │            │
          └──────────────────────────────┘            │
                                      └─ S103          │
                           │ ◄───────────────────────────┘
                           ▼
     No ── ◇ IS MONITORING CARRIED OUT WITH ◇
            ◇     GENERATED MODEL?          ◇
                                      └─ S104
                           │ Yes
                           ▼
          ┌──────────────────────────────┐
          │   DETECT MODEL BREAKAGE STATUS │
          └──────────────────────────────┘
                                      └─ S105
                           │
                           ▼
     No ── ◇ DOES MODEL BREAKAGE STATUS ◇
            ◇ SATISFY ALARM CONDITION?   ◇
                                      └─ S106
                           │ Yes
                           ▼
          ┌──────────────────────────────┐
          │    PROVIDE NOTIFICATION OF     │
          │    DETERMINATION RESULT        │
          └──────────────────────────────┘
                                      └─ S107
                           │
                           ▼
     No ── ◇ IS MANAGEMENT ENDED? ◇
                                └─ S108
                           │ Yes
                           ▼
                    ┌─────────────┐
                    │     END     │
                    └─────────────┘
```

43

## Fig. 9

START

↓

GENERATE CROSS-CORRELATION MODEL GROUP

S201

↓

EXTRACT FINE CROSS-CORRELATION MODEL GROUP

S202

↓

FORMULATE GRAPH STRUCTURE OF FINE CROSS-CORRELATION MODEL GROUP

S203

↓

CHOOSE REPRESENTATIVE DATA ITEM ACCORDING TO EACH CLUSTER

S204

↓

GENERATE MANY-BODY CORRELATION MODEL GROUP FOR ALL COMBINATIONS OF DATA ITEMS OBTAINED BY EXCLUDING REPRESENTATIVE DATA ITEM ACCORDING TO EACH CLUSTER

S205

↓

EXTRACT FINE MANY-BODY CORRELATION MODEL GROUP

S206

↓

STORE FINE MANY-BODY CORRELATION MODEL GROUP AS ANALYSIS MODEL

S207

↓

END

## Fig. 10

| Item | Time shift |
|------|------------|
| A | 0 |
| B | 3 |
| C | 2 |
| D | -1 |

Item B

Fig. 11

STATE INFORMATION
COLLECTION MEANS  11

STATE INFORMATION
STORAGE MEANS  14

ANALYSIS-MODEL
GENERATION MEANS  32

ANALYSIS MODEL CANDIDATE
GENERATION MEANS  321

CROSS-CORRELATION
MODEL GENERATION
MEANS  3213

DATA-ITEM
CLASSIFICATION
MEANS  1211

MANY-BODY
CORRELATION MODEL
GENERATION MEANS  1212

MODEL EXTRACTION
MEANS  322

ANALYSIS-MODEL
STORAGE MEANS  15

ANALYSIS MEANS  13

MODEL-BREAKAGE
DETECTION MEANS  131

ABNORMALITY
DETERMINATION
MEANS  132

SYSTEM-ANALYZING DEVICE

300

46

Fig. 12

```
                        ┌─────────────────┐
                        │      START      │
                        └─────────────────┘
                                 │
                                 ▼
  ┌─────────────────────────────────────────────────────────────┐
  │   GENERATE CROSS-CORRELATION MODEL GROUP FOR ANALYSIS        │
  └─────────────────────────────────────────────────────────────┘
                                 │              └─ S301
                                 ▼
  ┌─────────────────────────────────────────────────────────────┐
  │  EXTRACT FINE CROSS-CORRELATION MODEL GROUP FOR ANALYSIS     │
  └─────────────────────────────────────────────────────────────┘
                                 │              └─ S302
                                 ▼
  ┌─────────────────────────────────────────────────────────────┐
  │        GENERATE CROSS-CORRELATION MODEL GROUP (FOR           │
  │                    CLASSIFICATION)                            │
  └─────────────────────────────────────────────────────────────┘
                                 │              └─ S201
                                 ▼
  ┌─────────────────────────────────────────────────────────────┐
  │      EXTRACT FINE CROSS-CORRELATION MODEL GROUP (FOR         │
  │                    CLASSIFICATION)                            │
  └─────────────────────────────────────────────────────────────┘
                                 │              └─ S202
                                 ▼
  ┌─────────────────────────────────────────────────────────────┐
  │  FORMULATE GRAPH STRUCTURE OF FINE CROSS-CORRELATION         │
  │         MODEL GROUP (FOR CLASSIFICATION)                     │
  └─────────────────────────────────────────────────────────────┘
                                 │              └─ S203
                                 ▼
  ┌─────────────────────────────────────────────────────────────┐
  │     CHOOSE REPRESENTATIVE DATA ITEM ACCORDING TO EACH        │
  │                      CLUSTER                                  │
  └─────────────────────────────────────────────────────────────┘
                                 │              └─ S204
                                 ▼
  ┌─────────────────────────────────────────────────────────────┐
  │  GENERATE MANY-BODY CORRELATION MODEL GROUP FOR ALL          │
  │  COMBINATIONS OF DATA ITEMS, IN WHICH REPRESENTATIVE DATA    │
  │  ITEM IS EXCLUDED, ACCORDING TO EACH CLUSTER                 │
  └─────────────────────────────────────────────────────────────┘
                                 │              └─ S205
                                 ▼
  ┌─────────────────────────────────────────────────────────────┐
  │    EXTRACT FINE MANY-BODY CORRELATION MODEL GROUP           │
  └─────────────────────────────────────────────────────────────┘
                                 │              └─ S206
                                 ▼
  ┌─────────────────────────────────────────────────────────────┐
  │  STORE FINE CROSS-CORRELATION MODEL GROUP AND FINE MANY-     │
  │  BODY CORRELATION MODEL GROUP FOR ANALYSIS AS ANALYSIS       │
  │                       MODEL                                   │
  └─────────────────────────────────────────────────────────────┘
                                 │              └─ S303
                                 ▼
                        ┌─────────────────┐
                        │       END       │
                        └─────────────────┘
```

Fig. 13

400

SYSTEM-ANALYZING DEVICE  11

STATE INFORMATION
COLLECTION MEANS

14

STATE INFORMATION
STORAGE MEANS

32

ANALYSIS-MODEL
GENERATION MEANS  321

ANALYSIS MODEL CANDIDATE
GENERATION MEANS  3213

CROSS-CORRELATION
MODEL GENERATION
MEANS

DATA-ITEM
CLASSIFICATION
MEANS  1211

MANY-BODY
CORRELATION MODEL
GENERATION MEANS  1212

MODEL EXTRACTION
MEANS  322

15

ANALYSIS-MODEL
STORAGE MEANS

43

ANALYSIS MEANS  131

MODEL-BREAKAGE
DETECTION MEANS

ABNORMALITY
DETERMINATION
MEANS  132

434

MODEL-BREAKAGE
STORAGE MEANS

ABNORMALITY-
FACTOR EXTRACTION
MEANS  433

Fig. 14

START

↓

COLLECT AND STORE STATE INFORMATION
S101

↓

IS ANALYSIS MODEL GENERATED? ⟶ No
S102

↓ Yes

GENERATE ANALYSIS MODEL
S103

↓

IS MONITORING CARRIED OUT
WITH GENERATED MODEL? ⟵ No
S104

↓ Yes

DETECT MODEL BREAKAGE STATUS
S105

↓

DOES MODEL BREAKAGE STATUS
SATISFY ALARM CONDITION? ⟵ No
S106

↓ Yes

PROVIDE NOTIFICATION OF
DETERMINATION RESULT
S107

↓

EXTRACT CANDIDATE FOR ABNORMALITY
FACTOR AND PROVIDE NOTIFICATION THEREOF
S401

↓

IS MANAGEMENT ENDED? ⟵ No
S108

↓ Yes

END

## Fig. 15

| | MODEL BREAKAGE DOES NOT OCCUR |
| --- | --- |
| | MODEL BREAKAGE OCCURS |

COMMON METRIC: NONE    COMMON METRIC: NONE    COMMON METRIC: B

0: MODEL BREAKAGE DOES NOT OCCUR

1: MODEL BREAKAGE OCCURS

| | | Item | | | | | |
| --- | --- | --- | --- | --- | --- | --- | --- |
| | | A | B | C | D | G | H |
| Regression equation | $B=f_1(A,B)$ | 0 | 0 | 0 | 0 | 0 | 0 |
| | $C=f_2(A,C)$ | 0 | 0 | 0 | 0 | 0 | 0 |
| | $B=f_3(B,D)$ | 0 | 0 | 0 | 0 | 0 | 0 |
| | $C=f_4(C,D)$ | 0 | 0 | 1 | 1 | 0 | 0 |
| | $G=f_5(G,H)$ | 0 | 0 | 0 | 0 | 0 | 0 |
| | $C=f_{10}(A, B, C)$ | 1 | 1 | 1 | 0 | 0 | 0 |
| | $C=f_{11}(B, C, D)$ | 0 | 1 | 1 | 1 | 0 | 0 |
| Score | | 1/3 | 2/4 | 3/4 | 2/3 | 0/1 | 0/1 |

Fig. 16

ANALYSIS-MODEL GENERATION MEANS 51

DATA-ITEM CLASSIFICATION MEANS 511

MANY-BODY CORRELATION MODEL GENERATION MEANS 512

MODEL EXTRACTION MEANS 513

Fig. 17

ANALYSIS-MODEL GENERATION MEANS 51

ANALYSIS-MODEL STORAGE MEANS 52

ANALYSIS MEANS 53

MODEL-BREAKAGE DETECTION MEANS 531

ABNORMALITY DETERMINATION MEANS 532

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2010218187 A
- JP 2006350698 A
- JP 2003314933 A
- JP 5108116 B
- EP 2442288 A
- US 20110276828 A
- JP 2014065120 A